# EUROPEAN PATENT SPECIFICATION

(11) **EP 4 156 872 B1**
(45) Date of publication and mention of the grant of the patent: **18.06.2025**
(21) Application number: 21827886.9
(22) Date of filing: 21.06.2021
(51) Int. Cl.: H04N 23/54, H05K 1/14, H05K 1/11, H05K 3/36, H04N 23/57

(54) **ELECTRONIC DEVICE COMPRISING A CAMERA MODULE**
ELEKTRONISCHE VORRICHTUNG MIT EINEM KAMERAMODUL
DISPOSITIF ÉLECTRONIQUE COMPRENANT UN MODULE DE CAMÉRA

(30) Priority: 26.06.2020 KR 20200078567
(43) Date of publication of application: 29.03.2023
(73) Proprietor: Samsung Electronics Co., Ltd., Gyeonggi-do 16677 (KR)
(72) Inventor: JUNG, Hwajoong, Suwon-si, Gyeonggi-do 16677 (KR); KIM, Manho, Suwon-si, Gyeonggi-do 16677 (KR); JEONG, Wonjun, Suwon-si, Gyeonggi-do 16677 (KR); BYON, Kwangseok, Suwon-si, Gyeonggi-do 16677 (KR); LEE, Kihuk, Suwon-si, Gyeonggi-do 16677 (KR); CHOI, Yonghwan, Suwon-si, Gyeonggi-do 16677 (KR)
(74) Representative: Nederlandsch Octrooibureau
(86) International application number: PCT/KR2021/007731
(87) International publication number: WO 2021/261854

(56) References cited:
- EP-A1- 2 750 371
- CN-B- 104 849 943
- JP-A- 2006 184 544
- KR-A- 20130 047 350
- KR-A- 20180 036 274
- KR-A- 20180 042 948
- KR-A- 20200 005 436
- US-A1- 2013 182 325

## Description

### [Technical Field]

Embodiments of the disclosure described herein relate to a camera module and an electronic device including the same.

### [Background Art]

An electronic device may include at least one camera module. The camera module may include an auto focus function of correcting the focus of an image. For example, the electronic device may perform the auto focus function by moving a lens of the camera module in the direction of an optical axis. In addition, the camera module may include an image stabilization function of compensating for a shake. For example, the electronic device may perform the image stabilization function by rotating the lens of the camera module.

US 2013/182325 A1, 18 July 2013, is about an optical unit with shake correction function wherein it is possible to accurately swing the movable module even when a flexible wiring substrate is connected to the fixing element and movable module. In an optical unit with shake correction function, folding portions, the extending direction of which is reversed towards the vicinity of the swinging support point of a movable module, are provided at the midway portion of a flexible wiring substrate that is connected to the movable module and to a fixing element. In the folding portions, the overlapping portions of the flexible wiring substrate are fixed.

### [Disclosure]

### [Technical Problem]

The camera module may include a fixed part and a moving part. Each of the fixed part and the moving part may include an electric element. For example, the moving part may include an image sensor.

Embodiments of the disclosure provide a camera module including a connecting structure for supporting a movement of a moving part for an image stabilization function and providing electrical connection between the moving part and a fixed part, and an electronic device including the camera module.

The technical problems to be solved by the disclosure are not limited to the aforementioned problems, and any other technical problems not mentioned herein will be clearly understood from the following description by those skilled in the art to which the disclosure pertains.

### [Technical Solution]

The invention is set out in the appended set of claims.

### [ Advantageous Effects]

According to the embodiments of the disclosure, when an image stabilization function is performed, the moving part may freely move in a specified range within the fixed part, and electrical connection between an electric element included in the moving part and the fixed part may be stably maintained.

In addition, the disclosure may provide various effects that are directly or indirectly recognized.

### [ Description of Drawings]

FIG. 1 is a block diagram illustrating an electronic device in a network environment according to an embodiment.
FIG. 2 is a block diagram illustrating the camera module according to an embodiment.
FIG. 3A is a front perspective view of an electronic device according to an embodiment.
FIG. 3B is a rear perspective view of the electronic device according to an embodiment.
FIG. 3C is an exploded perspective view of the electronic device according to an embodiment.
FIG. 4 is a view illustrating a camera module of the electronic device according to an embodiment.
FIG. 5 is a view illustrating a tilt operation of the camera module of the electronic device according to an embodiment.
FIG. 6A is a view illustrating a first circuit board and a second circuit board of the camera module of the electronic device according to an embodiment.
FIG. 6B is an exploded perspective view of the first circuit board, the second circuit board, and a connecting structure of the electronic device.
FIG. 6C is a view illustrating a first circuit board and a second circuit board of the electronic device according to another embodiment.
FIG. 7 is a view illustrating the first circuit board of the camera module of the electronic device according to an embodiment.
FIG. 8 is a view illustrating the second circuit board of the camera module of the electronic device according to an embodiment.
FIG. 9 is a view illustrating the connecting structure of the camera module of the electronic device according to an embodiment.
FIG. 10 is a view illustrating a flexible substrate of the camera module of the electronic device according to an embodiment.
FIG. 11A is a view illustrating the connecting structure of the camera module of the electronic device according to an embodiment.
FIG. 11B is a plan view of a first portion of the connecting structure of the camera module of the electronic device according to an embodiment.
FIG. 11C is a plan view of a second portion of the connecting structure of the camera module of the electronic device according to an embodiment.
FIG. 12 is a view illustrating the connecting structure of the camera module of the electronic device according to an embodiment.
FIG. 13 is a view illustrating a rotation operation of the camera module of the electronic device according to an embodiment.
FIG. 14 is a view illustrating a connecting structure of a camera module of the electronic device according to another embodiment.
FIG. 15 is a view illustrating the connecting structure of the camera module of the electronic device according to the other embodiment.
FIG. 16 is a view illustrating the connecting structure of the camera module of the electronic device according to the other embodiment.
FIG. 17 is a view illustrating a rotation operation of the camera module of the electronic device according to the other embodiment.
FIG. 18 is a view illustrating a connecting structure of a camera module of the electronic device according to various embodiments.
FIG. 19 is a view illustrating a rotation operation of the camera module of the electronic device according to various embodiments.

In the following description made with respect to the accompanying drawings, similar components will be assigned with similar reference numerals.

### [ Mode for Invention]

Hereinafter, various embodiments of the disclosure may be described with reference to accompanying drawings.

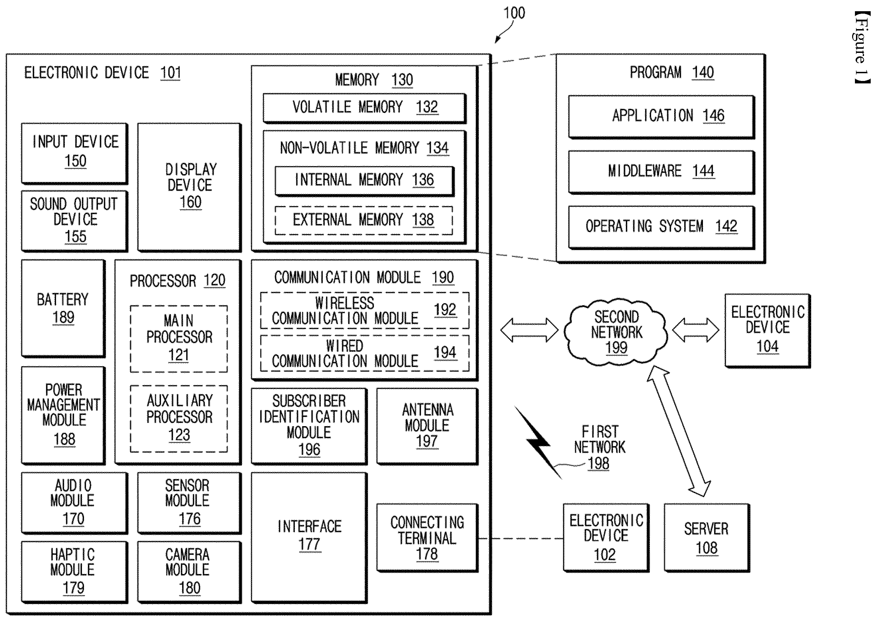

FIG. 1 is a block diagram illustrating an electronic device in a network environment according to an embodiment.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module (SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140may be stored in the memory 130 as software, and may include, for example, an operating system (OS) 142, middleware 144, or an application 146.

The input device 150 may receive a command or data to be used by other component (e.g., the processor 120) of the electronic device 101, from the outside (e.g., a user) of the electronic device 101. The input device 150 may include, for example, a microphone, a mouse, a keyboard, or a digital pen (e.g., a stylus pen).

The sound output device 155 may output sound signals to the outside of the electronic device 101. The sound output device 155 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 150, or output the sound via the sound output device 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., PCB). According to an embodiment, the antenna module 197 may include a plurality of antennas. In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

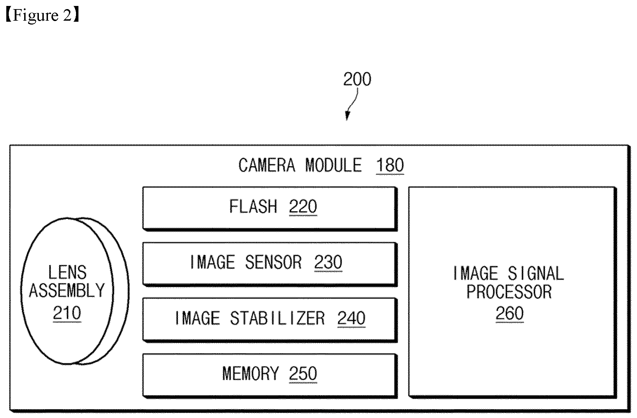

FIG. 2 is a block diagram 200 illustrating the camera module according to an embodiment.

Referring to FIG. 2, the camera module 180 may include a lens assembly 210, a flash 220, an image sensor 230, an image stabilizer 240, memory 250 (e.g., buffer memory), or an image signal processor 260.

At least one of the components (e.g., the lens assembly 210, the flash 220, the image sensor 230, the image stabilizer 240, and the memory 250) included in the camera module 180 may operate under the control of a control circuit (e.g., the processor 120 of FIG. 1) of an electronic device (e.g., the electronic device 101 of FIG. 1). For example, the control circuitry (e.g., the processor 120 of FIG. 1) may include a main processor (e.g., the main processor 121 of FIG. 1) and/or an auxiliary processor (e.g. the auxiliary processor 123 of FIG. 1 or the image signal processor 260).

The lens assembly 210 may collect light emitted or reflected from an object whose image is to be taken. The lens assembly 210 may include one or more lenses. According to an embodiment, the camera module 180 may include a plurality of lens assemblies 210. In such a case, the camera module 180 may form, for example, a dual camera, a 360-degree camera, or a spherical camera. Some of the plurality of lens assemblies 210 may have the same lens attribute (e.g., view angle, focal length, auto-focusing, f number, or optical zoom), or at least one lens assembly may have one or more lens attributes different from those of another lens assembly. The lens assembly 210 may include, for example, a wide-angle lens or a telephoto lens.

The flash 220 may emit light that is used to reinforce light reflected from an object. According to an embodiment, the flash 220 may include one or more light emitting diodes (LEDs) (e.g., a red-green-blue (RGB) LED, a white LED, an infrared (IR) LED, or an ultraviolet (UV) LED) or a xenon lamp.

The image sensor 230 may obtain an image corresponding to an object by converting light emitted or reflected from the object and transmitted via the lens assembly 210 into an electrical signal. According to an embodiment, the image sensor 230 may include one selected from image sensors having different attributes, such as a RGB sensor, a black-and-white (BW) sensor, an IR sensor, or a UV sensor, a plurality of image sensors having the same attribute, or a plurality of image sensors having different attributes. Each image sensor included in the image sensor 230 may be implemented using, for example, a charged coupled device (CCD) sensor or a complementary metal oxide semiconductor (CMOS) sensor.

The image stabilizer 240 may move the image sensor 230 or at least one lens included in the lens assembly 210 in a particular direction, or control an operational attribute (e.g., adjust the read-out timing) of the image sensor 230 in response to the movement of the camera module 180 or the electronic device 101 including the camera module 180. This allows compensating for at least part of a negative effect (e.g., image blurring) by the movement on an image being captured. According to an embodiment, the image stabilizer 240 may sense such a movement by the camera module 180 or the electronic device 101 using a gyro sensor (not shown) or an acceleration sensor (not shown) disposed inside or outside the camera module 180. According to an embodiment, the image stabilizer 240 may be implemented, for example, as an optical image stabilizer.

The memory 250 may store, at least temporarily, at least part of an image obtained via the image sensor 230 for a subsequent image processing task. For example, if image capturing is delayed due to shutter lag or multiple images are quickly captured, a raw image obtained (e.g., a Bayer-patterned image, a high-resolution image) may be stored in the memory 250, and its corresponding copy image (e.g., a low-resolution image) may be previewed via the display device 160. Thereafter, if a specified condition is met (e.g., by a user's input or system command), at least part of the raw image stored in the memory 250 may be obtained and processed, for example, by the image signal processor 260. According to an embodiment, the memory 250 may be configured as at least part of the memory 130 or as a separate memory that is operated independently from the memory 130.

The image signal processor 260 may perform one or more image processing with respect to an image obtained via the image sensor 230 or an image stored in the memory 250. The one or more image processing may include, for example, depth map generation, three-dimensional (3D) modeling, panorama generation, feature point extraction, image synthesizing, or image compensation (e.g., noise reduction, resolution adjustment, brightness adjustment, blurring, sharpening, or softening). Additionally or alternatively, the image signal processor 260 may perform control (e.g., exposure time control or read-out timing control) with respect to at least one (e.g., the image sensor 230) of the components included in the camera module 180. An image processed by the image signal processor 260 may be stored back in the memory 250 for further processing, or may be provided to an external component (e.g., the memory 130, the display device 160, the electronic device 102, the electronic device 104, or the server 108) outside the camera module 180.

According to an embodiment, the image signal processor 260 may be configured as at least part of the processor 120, or as a separate processor that is operated independently from the processor 120. If the image signal processor 260 is configured as a separate processor from the processor 120, at least one image processed by the image signal processor 260 may be displayed, by the processor 120, via the display device 160 as it is or after being further processed.

According to an embodiment, the electronic device 101 may include a plurality of camera modules 180 having different attributes or functions. **In** such a case, at least one of the plurality of camera modules 180 may form, for example, a wide-angle camera and at least another of the plurality of camera modules 180 may form a telephoto camera. Similarly, at least one of the plurality of camera modules 180 may form, for example, a front camera and at least another of the plurality of camera modules180 may form a rear camera.

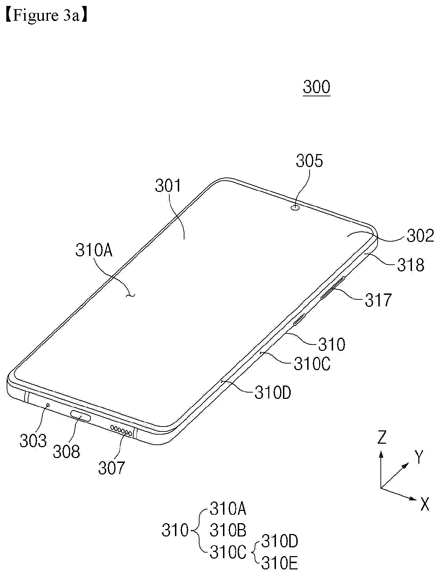

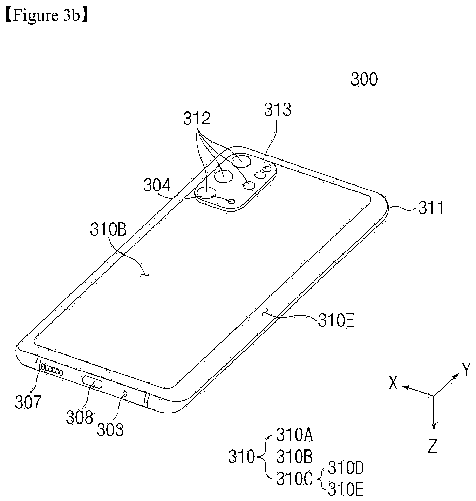

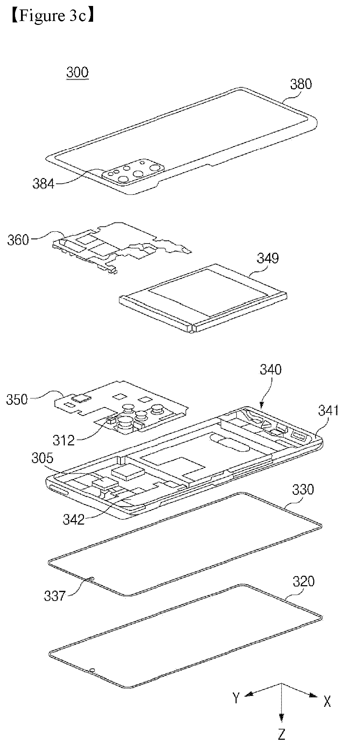

FIG. 3A is a front perspective view of an electronic device according to an embodiment. FIG. 3B is a rear perspective view of the electronic device according to an embodiment. FIG. 3C is an exploded perspective view of the electronic device according to an embodiment.

Referring to FIGS. 3A and 3B, the electronic device 300 may include a housing 310 that includes a first surface (or, a front surface) 310A, a second surface (or, a rear surface) 310B, and a side surface 310C surrounding a space between the first surface 310A and the second surface 310B.

In another embodiment (not illustrated), the housing 310 may refer to a structure that forms some of the first surface 310A, the second surface 310B, and the side surface 310C of FIG. 1.

In an embodiment, the first surface 310A may be formed by a front plate 302, at least a portion of which is substantially transparent (e.g., a glass plate including various coating layers, or a polymer plate). The second surface 310B may be formed by a back plate 311 that is substantially opaque. The back plate 311 may be formed of, for example, coated or colored glass, ceramic, a polymer, metal (e.g., aluminum, stainless steel (STS), or magnesium), or a combination of at least two of the aforementioned materials. The side surface 310C may be formed by a side bezel structure (or, a "frame structure") 318 that is coupled with the front plate 302 and the back plate 311 and that includes metal and/or a polymer.

In some embodiments, the back plate 311 and the side bezel structure 318 may be integrally formed with each other and may include the same material (e.g., a metallic material such as aluminum).

In the illustrated embodiment, the front plate 302 may include, at opposite long edges thereof, two first regions 310D that curvedly and seamlessly extend from the first surface 310A toward the back plate 311.

In the illustrated embodiment, the back plate 311 may include, at opposite long edges thereof, two second regions 310E that curvedly and seamlessly extend from the second surface 310B toward the front plate 302.

In some embodiments, the front plate 302 (or, the back plate 311) may include only one of the first regions 310D (or, the second regions 310E). In another embodiment, the front plate 302 (or, the back plate 311) may not include a part of the first regions 310D (or, the second regions 310E).

In the embodiments, when viewed from a side of the electronic device 300, the side bezel structure 318 may have a first thickness (or, width) at sides (e.g., short sides) not including the first regions 310D or the second regions 310E and may have a second thickness at sides (e.g., long sides) including the first regions 310D or the second regions 310E, the second thickness being smaller than the first thickness.

In an embodiment, the electronic device 300 may include at least one of a display 301, an audio module 303, 304, and 307 (e.g., the audio module 170 of FIG. 1), a sensor module (not illustrated) (e.g., the sensor module 176 of FIG. 1), camera modules 305 and 312 (e.g., the camera module 180 of FIG. 1), key input devices 317 (e.g., the input device 150 of FIG. 1), a light emitting element (not illustrated), or a connector hole 308 (e.g., the connecting terminal 178 of FIG. 1). In some embodiments, the electronic device 300 may not include at least one component (e.g., the key input devices 317) among the aforementioned components, or may additionally include other component(s) (e.g., a light emitting element (not illustrated)).

In an embodiment, the display 301 may be exposed through most of the front plate 302. In some embodiments, at least a portion of the display 301 may be exposed through the front plate 302 that includes the first surface 310A and the first regions 310D of the side surface 310C.

In some embodiments, the periphery of the display 301 may be formed to be substantially the same as the shape of the adjacent outside edge of the front plate 302. In another embodiment (not illustrated), to expand the area by which the display 301 is exposed, the gap between the periphery of the display 301 and the periphery of the front plate 302 may be formed to be substantially constant.

In an embodiment, a surface of the housing 310 (or, the front plate 302) may include a screen display region that is formed as the display 301 is visually exposed. For example, the screen display region may include the first surface 310A and the first regions 310D of the side surface.

In some embodiments, the screen display region 310A and 310D may include a sensing region (not illustrated) that is configured to obtain biometric information of a user. Here, when the screen display region 310A and 310D includes the sensing region, this may mean that at least a portion of the sensing region overlaps the screen display region 310A and 310D. For example, the sensing region may refer to a region capable of displaying visual information by the display 301 like the other regions of the screen display region 310A and 310D and additionally obtaining the user's biometric information (e.g., fingerprint).

In an embodiment, the screen display region 310A and 310D of the display 301 may include a region through which the first camera module 305 (e.g., a punch hole camera) is visually exposed. For example, at least a portion of the periphery of the region through which the first camera module 305 is exposed may be surrounded by the screen display region 310A and 310D. In an embodiment, the first camera module 305 may include a plurality of camera modules (e.g., the camera module 180 of FIG. 1).

In another embodiment (not illustrated), the display 301 may include, on a rear surface of the screen display region 310A and 310D, at least one of the audio module 303, 304, and 307, a sensor module (e.g., the sensor module 176 of FIG. 1), a camera module (e.g., the first camera module 305), or a light emitting element (not illustrated). For example, the camera module (e.g., the first camera module 305) may be disposed on a rear side (e.g., a side facing the -Z-axis direction) of the first surface 310A (e.g., the front surface) and/or the side surface 310C (e.g., at least one of the first regions 310D) so as to face toward the first surface 310A and/or the side surface 310C. For example, the first camera module 305 may include an under display camera (UDC) that is hidden without being visually exposed on the screen display region.

In some embodiments (not illustrated), the display 301 may be coupled with, or disposed adjacent to, touch detection circuitry, a pressure sensor capable of measuring the intensity (pressure) of a touch, and/or a digitizer for detecting a stylus pen of a magnetic type.

In an embodiment, the audio module 303, 304, and 307 may include the microphone holes 303 and 304 and the speaker hole 307.

In an embodiment, a microphone for obtaining an external sound may be disposed in the microphone hole 303. In some embodiments, the microphone may include a plurality of microphones to detect the direction of a sound. In some embodiments, the microphone hole 304 formed in a partial region of the second surface 310B may be disposed adjacent to the camera modules 305 and 312. For example, the microphone hole 304 may obtain a sound when the camera modules 305 and 312 are executed, or may obtain a sound when another function is executed.

In an embodiment, the speaker hole 307 may include an external speaker hole 307 and a receiver hole for telephone call (not illustrated). In some embodiments, the speaker hole 307 and the microphone hole 303 may be implemented as a single hole.

In an embodiment, the electronic device 300 may include a speaker fluidly connected with the speaker hole 307. In some embodiments, the speaker may include a piezoelectric speaker from which the speaker hole 307 is omitted.

In an embodiment, the sensor module (not illustrated) (e.g., the sensor module 176 of FIG. 1) may generate an electrical signal or a data value that corresponds to an operational state inside the electronic device 300 or an environmental state external to the electronic device 300. In an embodiment, the sensor module (not illustrated) may be disposed on the first surface 310A and/or the second surface 310B of the housing 310. For example, the sensor module may include at least one of a proximity sensor, an HRM sensor, a fingerprint sensor, a gesture sensor, a gyro sensor, an atmospheric pressure sensor, a magnetic sensor, an acceleration sensor, a grip sensor, a color sensor, an infrared (IR) sensor, a biosensor, a temperature sensor, a humidity sensor, or an illuminance sensor. In an embodiment, at least a portion of the sensor module may be disposed on the side surface 310C of the housing 310 (e.g., the first regions 310D and/or the second regions 310E).

In an embodiment, the camera modules 305 and 312 may include the first camera module 305 (e.g., a punch hole camera) exposed on the first surface 310A of the electronic device 300, the second camera module 312 exposed on the second surface 310B of the electronic device 300, and/or a flash 313.

In an embodiment, the first camera module 305 may be exposed through a portion of the screen display region 310A and 310D of the display 301. For example, the first camera module 305 may be exposed on a partial region of the screen display region 310A and 310D through an opening (not illustrated) that is formed in a portion of the display 301.

In an embodiment, the second camera module 312 may include a plurality of camera modules (e.g., a dual camera or a triple camera). However, the second camera module 312 is not necessarily limited to including the plurality of camera modules and may include one camera module.

The first camera module 305 and the second camera module 312 may include one or more lenses, an image sensor, and/or an image signal processor. The flash 313 may include, for example, a light emitting diode or a xenon lamp. In some embodiments, two or more lenses (an IR camera lens, a wide angle lens, and a telephoto lens) and image sensors may be disposed on one surface of the electronic device 300.

In an embodiment, the key input devices 317 may be disposed on the side surface 310C (e.g., the first regions 310D and/or the second regions 310E) of the housing 310. In some embodiments, the electronic device 300 may not include all or some of the aforementioned key input devices 317, and the key input devices 317 not included may be implemented in a different form, such as a soft key, on the display 301. In some embodiments, the key input devices may include a sensor module (not illustrated) that forms the sensing region (not illustrated) that is included in the screen display region 310A and 310D.

In an embodiment, the connector hole 308 may accommodate a connector. In an embodiment, the connector hole 308 may be disposed in the side surface 310C of the housing 310. In some embodiments, the electronic device 300 may include the first connector hole 308 capable of accommodating a connector (e.g., a USB connector) for transmitting and receiving power and/or data with an external electronic device, and/or a second connector hole (not illustrated) capable of accommodating a connector (e.g., an earphone jack) for transmitting and receiving audio signals with an external electronic device.

In an embodiment, the electronic device 300 may include a light emitting element (not illustrated). For example, the light emitting element may be disposed on the first surface 310A of the housing 310. The light emitting element may provide state information of the electronic device 300 in the form of light. In some embodiments, the light emitting element may provide a light source operating in conjunction with the first camera module 305. For example, the light emitting element may include an LED, an IR LED, and/or a xenon lamp.

Referring to FIG. 3C, the electronic device 300 may include a front plate 320 (e.g., the front surface 310A and the first regions 310D of FIG. 3A), a display 330 (e.g., the display 301 of FIG. 3A), a bracket 340, a battery 349, a printed circuit board 350 (e.g., a printed circuit board (PCB), a flexible PCB (FPCB), or a rigid-flexible PCB (RFPCB)), a support member 360 (e.g., a rear case), and a back plate 380 (e.g., the rear surface 310B and the second regions 310E of FIG. 3A).

In some embodiments, the electronic device 300 may not include at least one component (e.g., the support member 360) among the aforementioned components, or may additionally include other component(s). At least one of the components of the electronic device 300 may be the same as, or similar to, at least one of the components of the electronic device 300 of FIGS. 3A and 3B, and repetitive descriptions will hereinafter be omitted.

In an embodiment, the front plate 320, the back plate 380, and at least a portion of the bracket 340 (e.g., a frame structure 341) may form the housing (e.g., the housing 310 of FIGS. 3A and 3B).

In an embodiment, the bracket 340 may include the frame structure 341 that forms a surface of the electronic device 300 (e.g., a portion of the side surface 310C of FIG. 1) and a plate structure 342 extending from the frame structure 341 into the electronic device 300.

In an embodiment, the plate structure 342 may be located inside the electronic device 300 and may be connected with the frame structure 341, or may be integrally formed with the frame structure 341. The plate structure 342 may be formed of, for example, a metallic material and/or a nonmetallic (e.g., polymer) material. The display 330 may be coupled to one surface of the plate structure 342, and the printed circuit board 350 may be coupled to an opposite surface of the plate structure 142. The printed circuit board 350 may have a processor, a memory, and/or an interface mounted thereon. The processor may include, for example, one or more of a central processing unit, an application processor, a graphic processing unit, an image signal processor, a sensor hub processor, or a communication processor.

In an embodiment, the memory may include, for example, a volatile memory or a nonvolatile memory.

In an embodiment, the interface may include, for example, a high definition multimedia interface (HDMI), a universal serial bus (USB) interface, an SD card interface, and/or an audio interface. For example, the interface may electrically or physically connect the electronic device 300 with an external electronic device and may include a USB connector, an SD card/MMC connector, or an audio connector.

In an embodiment, the battery 349 may supply power to at least one of the components of the electronic device 300. For example, the battery 349 may include a primary cell that is not rechargeable, a secondary cell that is rechargeable, or a fuel cell. In an embodiment, at least a portion of the battery 349 may be disposed on substantially the same plane as the printed circuit board 350. In an embodiment, the battery 349 may be integrally disposed inside the electronic device 300, or may be disposed so as to be detachable from the electronic device 300.

In an embodiment, the first camera module 305 may be disposed on the plate structure 342 of the bracket 340 such that a lens is visually exposed through a partial region of the front plate 320 (e.g., the front surface 310A of FIG. 1) of the electronic device 300.

In an embodiment, the first camera module 305 may be disposed such that the optical axis of the lens is at least partially aligned with a hole or recess 337 formed in the display 330. For example, the region through which the lens is exposed may be formed in the front plate 320. For example, the first camera module 305 may include a punch hole camera, at least a portion of which is disposed in the hole or recess 337 formed in a rear surface of the display 330.

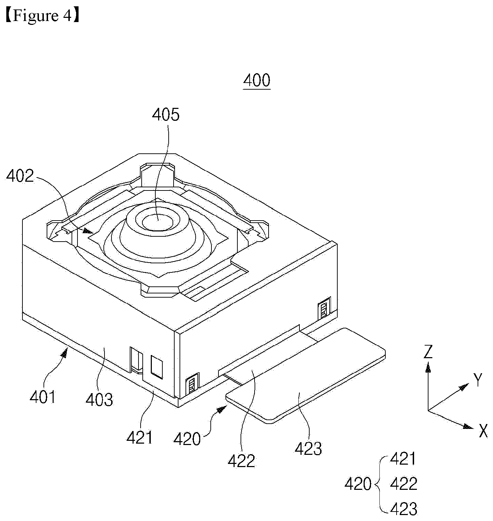

In an embodiment, the second camera module 312 may be disposed on the printed circuit board 350 such that a lens is exposed through a camera region 384 of the back plate 380 (e.g., the rear surface 310B of FIG. 2) of the electronic device 300. In another embodiment, the second camera module 312 may be disposed in at least a portion of an inner space (e.g., a space formed by the plate structure 342) that is formed in the housing 310 of the electronic device 300 and may be electrically connected to the printed circuit board 350 through a connection member (e.g., a connector (e.g., a connector 423 of FIG. 4)).

In an embodiment, the camera region 384 may be formed in a surface (e.g., the rear surface 310B of FIG. 2) of the back plate 380. In an embodiment, the camera region 384 may be formed to be at least partially transparent such that external light is incident on the lens of the second camera module 312. In an embodiment, at least a portion of the camera region 384 may protrude to a predetermined height from the surface of the back plate 380. However, without being necessarily limited thereto, the camera region 384 may form substantially the same plane as the surface of the back plate 380.

FIG. 4 is a view illustrating a camera module of the electronic device according to an embodiment.

Referring to FIG. 4, the camera module 400 (e.g., the camera module 180 of FIGS. 1 and 2 and the camera module 312 of FIG. 3) may include a fixed part 401 fixedly disposed in the electronic device (e.g., the electronic device 300 of FIGS. 3A to 3C) and a moving part 402, at least a portion of which is disposed in the fixed part 401. In an embodiment, the fixed part 401 may include a first circuit board 420.

In an embodiment, the moving part 402 may include a lens 405 (e.g., the lens assembly 210 of FIG. 2). In an embodiment, the lens 405 included in the moving part 402 may be at least partially exposed outside the fixed part 401 through an opening formed in the fixed part 401. For example, the lens 405 may be visible through the opening. For example, the moving part 402 may be configured such that the lens 405 receives light external to the electronic device through a partial region (e.g., the camera region 384 of FIG. 3C) of a surface (e.g., the back plate 380 of FIG. 3C) of the housing of the electronic device (e.g., the electronic device 300 of FIG. 3). For example, the region through which the lens 405 is exposed may include a transparent region of the housing of the electronic device. In an embodiment, the moving part 402 may further include an image sensor (e.g., the image sensor 230 of FIG. 2) configured to convert a light signal received through the lens 405 into an electrical signal.

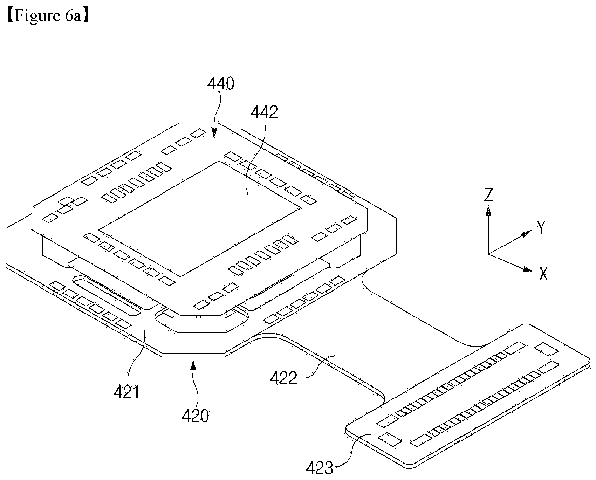

In an embodiment, at least a portion of the moving part 402 may be accommodated in the fixed part 401. The fixed part 401 may include the first circuit board 420. For example, the first circuit board 420 may include a second region 422 extending outward from the inside of the fixed part 401 and the connector 423 disposed on the second region 422. The connector 423 may be coupled to the printed circuit board (e.g., the printed circuit board 350 of FIG. 3C) of the electronic device (e.g., the electronic device 300 of FIGS. 3A to 3C). For example, an electrical signal generated by the image sensor of the moving part 402 (e.g., the image sensor 230 of FIG. 2 or an image sensor 442 of FIG. 6A) may be transferred to the printed circuit board (e.g., the printed circuit board 350 of FIG. 3C) of the electronic device (e.g., the electronic device 300 of FIG. 3) through the second region 422 of the first circuit board420 and the connector 423. In various embodiments, the fixed part 401 may be formed in the form of a camera housing 403 in which the moving part 402 is accommodated.

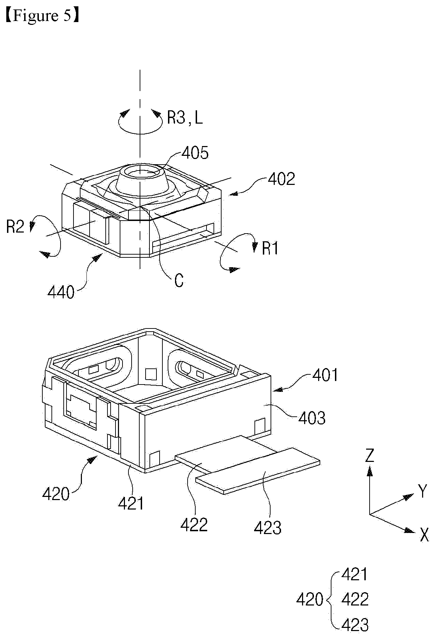

FIG. 5 is a view illustrating a tilt operation of the camera module of the electronic device according to an embodiment.

In an embodiment, the camera module 400 may include the fixed part 401, the moving part 402, and a connecting structure (not illustrated).

In an embodiment, the fixed part 401 may include the camera housing 403 and the first circuit board 420, at least a portion of which is disposed in the camera housing 403. The first circuit board 420 may include a first region 421 disposed in the camera housing 403, the second region 422 flexibly extending outside the camera housing 403 from the first region 421, and the connector 423 disposed on the second region 422.

In an embodiment, the moving part 402 may include the lens 405, the image sensor (e.g., the image sensor 230 of FIG. 2 or the image sensor 442 of FIG. 6A), and a second circuit board 440 electrically connected with the image sensor 442. In an embodiment, the image sensor 442 may be configured to convert a light signal received from the lens 405 into an electrical signal. In an embodiment, the image sensor 442 may be disposed on the second circuit board 440, or may be electrically connected to the second circuit board 440 through a wire. In an embodiment, the second circuit board 440 may be disposed to face the first region 421 of the first circuit board 420. For example, the second circuit board 440 may be disposed such that the image sensor 442 is aligned with an optical axis L of the lens 405.

In an embodiment, the moving part 402 may be coupled to the fixed part 401 so as to be rotatable. For example, the moving part 402 may be configured to rotate about the center of rotation C. For example, the center of rotation C may be located inside the moving part 402, or may be located between the moving part 402 and the fixed part 401. For example, the center of rotation C may be a point through which the optical axis L of the lens 405 passes. For example, the optical axis L may be defined as a straight line connecting the center of symmetry of a refractive surface or a reflective surface of the lens 405. For example, the optical axis L may be a central axis of rotation in the spherical or aspheric (e.g., parabolic or hyperbolic) lens 405.

In an embodiment, the moving part 402 may be configured to rotate about at least one rotational axis R1, R2, and R3 perpendicular to the optical axis L of the lens 405. In an embodiment, the moving part 402 may be configured to rotate about at least one rotational axis R1, R2, and R3 parallel to the optical axis L of the lens 405. In the illustrated embodiment, the first rotational axis R1 and the second rotational axis R2 substantially perpendicular to the optical axis L of the lens 405 may be defined. For example, the first rotational axis R1 and the second rotational axis R2 may be substantially perpendicular to each other. In various embodiments, the center of rotation C may be a point at which the rotational axes substantially intersect one another.

In an embodiment, the lens 405 may be moved (e.g., in the Z/-Z-axis direction) with respect to the optical axis L of the lens 405 in a space formed in the camera housing 403. For example, the lens 405 may linearly move in the direction of the optical axis L together with a structure (e.g., a lens carrier or a lens assembly (e.g., the lens assembly 210 of FIG. 2)) included in the moving part 402. For example, the camera module 400 may provide an auto focus (AF) function by moving the lens 405 in a direction (e.g., the Z/-Z-axis direction) substantially parallel to the optical axis L of the lens 405. For example, the camera module 400 may include an actuator (not illustrated) (e.g., a coil and/or a magnet) related to the auto focus function and may perform the auto focus function using the actuator. In an embodiment, under the control of an image signal processor (e.g., the image signal processor 260 of FIG. 2) and/or a processor (e.g., the processor 120 of FIG. 1), the camera module 400 may control an electromagnetic force by controlling a current (e.g., intensity and direction) flowing through the coil and may move a lens carrier 410 in a direction substantially parallel to the optical axis L by using the Lorentz force by the electromagnetic force.

In an embodiment, the moving part 402 may be configured to be rotatable about the first rotational axis R1 and/or the second rotational axis R2. For example, the moving part 402 may rotate relative to the fixed part 401. According to an embodiment, the camera module 400 may perform an image stabilization function (e.g., an OIS function). For example, the camera module 400 may perform a shake compensation function (e.g., an image stabilization function) by rotating the moving part 402 about the first rotational axis R1 and/or the second rotational axis R2. For example, the camera module 400 may include an actuator (not illustrated) (e.g., a coil and/or a magnet) related to the image stabilization function and may perform the image stabilization function using the actuator. In an embodiment, under the control of the image signal processor (e.g., the image signal processor 260 of FIG. 2) and/or the processor (e.g., the processor 120 of FIG. 1), the camera module 400 may control an electromagnetic force by controlling a current (e.g., intensity and direction) flowing through the coil and may rotate the moving part 402 about the first rotational axis R1 and/or the second rotational axis R2 by using the Lorentz force by the electromagnetic force.

In an embodiment, the moving part 402 may rotate about the first rotational axis R1 and/or the second rotational axis R2 such that the optical axis L of the lens 405 has a predetermined range (e.g., movement range) with respect to the Z-axis. For example, the camera module 400 may include a guide member (not illustrated) (e.g., a guide plate) related to a movement range of the moving part 402.

According to various embodiments, a 3-axis rotary motion related to a movement of the moving part 402 may include a rolling motion, a pitching motion, or a yawing motion. For example, a motion related to the first rotational axis R1 may be defined as a rolling motion, and a motion related to the second rotational axis R2 may be defined as a pitching motion. Additionally, for example, a motion related to the third rotational axis R3 may be defined as a yawing motion. According to various embodiments, the third rotational axis R3 may be an axis orthogonal to an orthogonal plane of the rolling motion and the pitching motion. In various embodiments, the third rotational axis R3 may substantially coincide with the optical axis L of the lens 405.

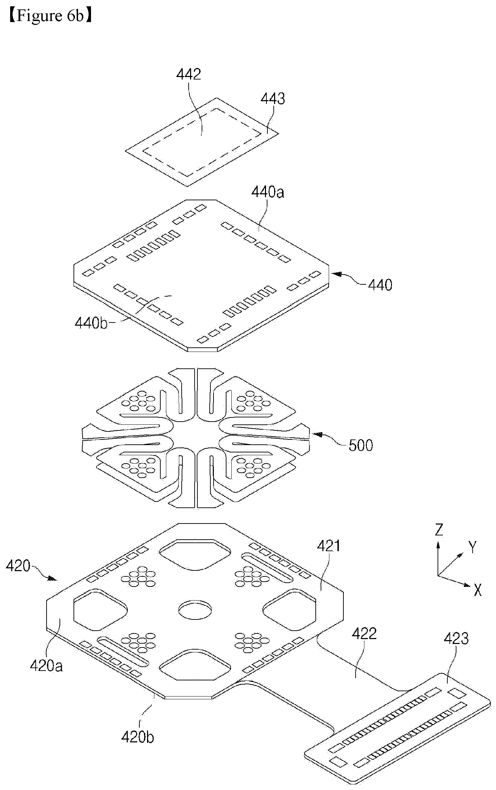

In an embodiment, a connecting structure (e.g., a connecting structure 500 of FIG. 6B) may electrically and/or physically connect the second circuit board 440 included in the moving part 402 and the first circuit board 420 included in the fixed part 401. For example, the connecting structure may be physically coupled to the first circuit board 420 and the second circuit board 440 to electrically connect the first circuit board 420 and the second circuit board 440.

The connecting structure of the camera module 400 according to an embodiment may be configured to maintain the physical coupling and/or electrical connection between the fixed part 401 and the moving part 402 when the moving part 402 of the camera module 400 moves relative to the fixed part 401. For example, the connecting structure may electrically connect the first circuit board 420 and the second circuit board 440 without affecting a movement (e.g., rotation) of the moving part 402.

FIG. 6A is a view illustrating the first circuit board and the second circuit board of the camera module of the electronic device according to an embodiment. FIG. 6B is an exploded perspective view illustrating the first circuit board, the second circuit board, and the connecting structure of the electronic device according to an embodiment.

Referring to FIGS. 6A and 6B, the camera module 400 may include the first circuit board 420, the second circuit board 440, and the connecting structure 500.

In an embodiment, the second circuit board 440 may be included in the moving part of the camera module 400 (e.g., the moving part 402 of FIG. 5). In an embodiment, the second circuit board 440 may include a third surface 440a facing the Z-axis direction and a fourth surface 440b facing away from the third surface 440a. In an embodiment, when the moving part 402 moves, the third surface 440a and the fourth surface 440b of the second circuit board 440 may be defined as surfaces facing the direction of the optical axis L of the lens (e.g., the lens 405 of FIG. 5). In an embodiment, the second circuit board 440 may be configured to rotate together with the moving part 402 when the electronic device (e.g., the electronic device 300 of FIGS. 3A to 3C) performs an image stabilization function.

In an embodiment, the second circuit board 440 may be electrically connected with the image sensor 442. For example, referring to the drawings, the image sensor 442 may be disposed on the third surface 440a of the second circuit board 440. For example, the image sensor 442 may be surface-mounted on the second circuit board 440. The image sensor 442 according to an embodiment is not limited to being disposed on the third surface 440a of the second circuit board 440. For example, the image sensor 442 may be disposed in an opening region (not illustrated) that is formed in the second circuit board 440 and may be electrically connected to the first circuit board 420 through a connecting member (e.g., wire bonding). Referring to FIG. 6B, the second circuit board 440 may further include an infrared filter 443 that overlaps at least a portion of the image sensor 442 when viewed in the Z-axis direction.

In an embodiment, the infrared filter 443 may have an area greater than or substantially the same as the area of the image sensor 442.

In an embodiment, the first circuit board 420 may be included in the fixed part of the camera module 400 (e.g., the fixed part 401 of FIG. 5). In an embodiment, the first circuit board 420 may include a first surface 420a facing the Z-axis direction and a second surface 420b facing away from the first surface 420a (e.g., a surface facing the -Z-axis direction).

In an embodiment, the first circuit board 420 may include the first region 421 at least partially facing the second circuit board 440, the second region 422 extending from the first region 421, and the connector 423 disposed on the second region 422. The connector 423 may be coupled to the printed circuit board (e.g., the printed circuit board 350 of FIG. 3C) included in the electronic device (e.g., the electronic device 300 of FIGS. 3A to 3C).

In an embodiment, the first circuit board 420 may be spaced apart from the second circuit board 440 by a predetermined gap. For example, the first surface 420a of the first circuit board 420 may be spaced apart from the fourth surface 440b of the second circuit board 440 by the predetermined gap while facing the fourth surface 440b of the second circuit board 440. For example, the first circuit board 420 may be disposed such that the first region 421 at least partially faces the fourth surface 440b of the second circuit board 440.

In an embodiment, at least a portion of the first circuit board 420 may be formed to be flexible. For example, the first region 421 may be formed to be rigid, and the second region 422 may be formed to be flexible. In an embodiment, the first circuit board 420 may be electrically connected with the second circuit board 440 through the connecting structure 500.

In an embodiment, the connecting structure 500 may be disposed in a space between the first surface 420a of the first circuit board 420 and the fourth surface 440b of the second circuit board 440. In an embodiment, the connecting structure 500 may extend from the first surface 420a of the first circuit board 420 to the fourth surface 440b of the second circuit board 440. In an embodiment, the connecting structure 500 may provide electrical connection between the first circuit board 420 and the second circuit board 440. For example, an electrical signal generated by the image sensor 442 may be transmitted to the first circuit board 420 through the second circuit board 440 and/or the connecting structure 500. The electrical signal may be transmitted to the processor of the electronic device (e.g., the processor 120 of FIG. 1) through the connector 423 of the first circuit board 420. In an embodiment, the connecting structure 500 may include at least one flexible substrate, at least a portion of which is formed to be flexible.

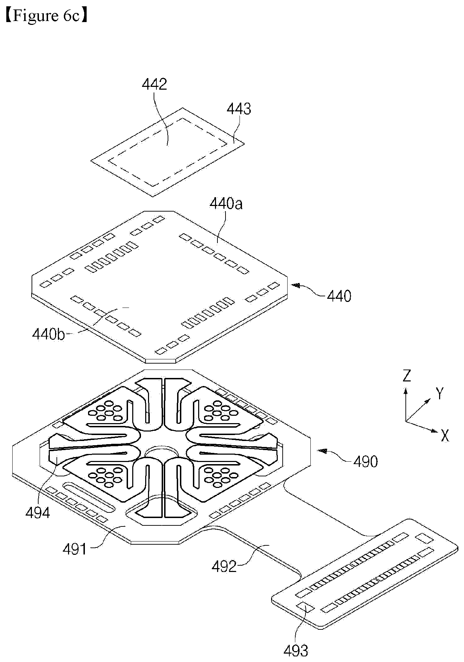

FIG. 6C is a view illustrating a first circuit board 490 and a second circuit board 440 of the electronic device according to another embodiment. The first circuit board 490 illustrated in FIG. 6C may be understood as the first circuit board 420 and the connecting structure 500 of FIG. 6B that are integrally connected with each other. In describing the first circuit board 490, repetitive descriptions identical to ones given with reference to FIGS. 6A and 6B will be omitted.

In the other embodiment, the first circuit board 490 may include a first region 491, a second region 492, a connecting region 494, and a connector 493. The first region 491 may at least partially face a fourth surface 440b of the second circuit board 440. The second region 492 may extend from the first region 491 to one side. The second region 492 may extend toward the printed circuit board (e.g., the printed circuit board 350 of FIG. 3C) disposed in the electronic device (e.g., the electronic device 300 of FIG. 3C). The connector 493 may be disposed on the second region 492. The connector 493 may be coupled to a corresponding connector of the printed circuit board 350 of the electronic device 300.

In the other embodiment, the connecting region 494 may extend from the first region 491 and may be electrically and physically coupled with the second circuit board 440. For example, the connecting region 494 may be formed to be flexible. For example, the connecting region 494 may electrically connect the second circuit board 440 and the first region 491 of the first circuit board 490.

In various embodiments, the first circuit board 490 may be formed to be partially flexible. For example, the first region 491 of the first circuit board 490 may be formed to be rigid, and the second region 492 and the connecting region 494 of the first circuit board 490 may be formed to be flexible.

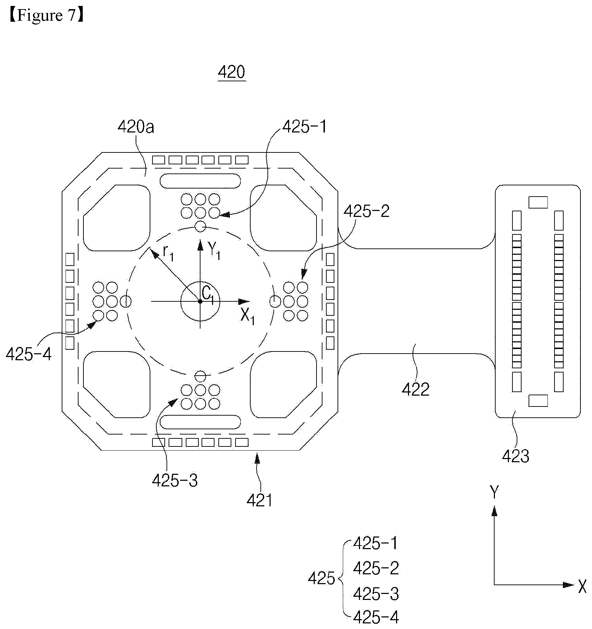

FIG. 7 is a view illustrating the first circuit board of the camera module of the electronic device according to an embodiment.

Referring to FIG. 7, the first circuit board 420 may include at least one first conductive region 425. For example, the first conductive region 425 may be formed on the first surface 420a of the first region 421 of the first circuit board 420.

In an embodiment, the first conductive region 425 may include a conductive region 1-1 425-1, a conductive region 1-2 425-2, a conductive region 1-3 425-3, and a conductive region 1-4 425-4. According to an embodiment, the first circuit board 420 is not limited to including four first conductive regions 425 and may include a plurality of (e.g., two, three, or five) first conductive regions 425.

In an embodiment, the first conductive region 425 may be formed in a position spaced apart from a first center point C1 of the first circuit board 420 by a first distance r1 in a radial direction. For example, the first center point C1 of the first circuit board 420 may be defined as a geometric center of the first region 421 of the first circuit board 420. For example, the first center point C1 may be defined as the center of the first region 421 in the X-axis direction and the Y-axis direction. In various embodiments, the first center point C1 may be a point through which a virtual line extending from the optical axis of the lens (e.g., the optical axis L of FIG. 5) passes in a state (e.g., a default state) in which the moving part 402 is not rotated.

In various embodiments, the first conductive regions 425-1, 425-2, 425-3, and 425-4 may have substantially the same radius when viewed based on a virtual circle having the first center point C1 as the center.

In an embodiment, the conductive region 1-1 425-1 may be located in the +Y-axis direction with respect to the first center point C1. The conductive region 1-2 425-2 may be located in the +X-axis direction with respect to the first center point C1. The conductive region 1-3 425-3 may be located in the -Y-axis direction with respect to the first center point C1. The conductive region 1-4 425-4 may be located in the -X-axis direction with respect to the first center point C1.

In an embodiment, the first conductive regions 425-1, 425-2, 425-3, and 425-4 may be disposed at the same intervals. For example, one of the first conductive regions 425-1, 425-2, 425-3, and 425-4 may be spaced apart from another first conductive region adjacent thereto at substantially the same angle. For example, referring to the drawing, one of the first conductive regions 425-1, 425-2, 425-3, and 425-4 may be spaced apart from another first conductive region adjacent thereto at a first angle (e.g., about 90 degrees). However, the angle between the first conductive regions 425-1, 425-2, 425-3, and 425-4 may vary depending on the number of first conductive regions and is not limited to the first angle (e.g., 90 degrees).

In an embodiment, the first conductive regions 425-1, 425-2, 425-3, and 425-4 may have point symmetry with respect to the first center point C1. For example, the conductive region 1-1 425-1 and the conductive region 1-3 425-3 may be symmetrical to each other with respect to an axis X1 that passes through the first center point C1 and is parallel to the X-axis. In an embodiment, the conductive region 1-2 425-2 and the conductive region 1-4 425-4 may be symmetrical to each other with respect to an axis Y1 that passes through the first center point C1 and is parallel to the Y-axis.

In various embodiments, an edge region in which the first conductive regions 425-1, 425-2, 425-3, and 425-4 are formed may be defined in the first region 421 of the first circuit board 420. The edge region may be at least partially aligned with an edge region of the second circuit board 440, which will be described below, in the Z-axis direction or the direction of the optical axis (e.g., the optical axis L of FIG. 5) of the lens (e.g., the lens 405 of FIG. 5).

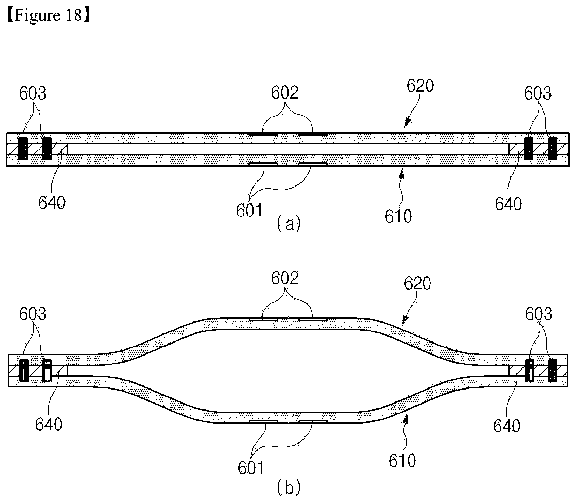

According to an embodiment, without being limited to those illustrated in the drawing, the positions and/or sizes of the first conductive regions 425-1, 425-2, 425-3, and 425-4 may be formed in various forms. For example, the first conductive regions 425-1, 425-2, 425-3, and 425-4 may be formed in various forms depending on the shape of the flexible substrate of the connecting structure (e.g., the connecting structure 500 of FIG. 5). For example, in a case in which a first conductive pad (e.g., a first conductive pad 601 of FIG. 18) is formed on a central region of a first flexible substrate (e.g., a first flexible substrate 610 of FIG. 18) as illustrated in FIG. 18, the first circuit board 420 may include first conductive regions corresponding to the position and/or size of the first conductive pad.

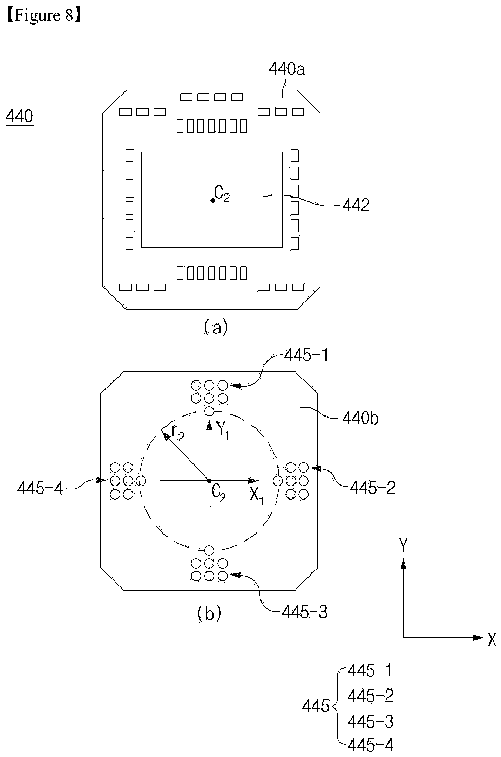

FIG. 8 is a view illustrating the second circuit board of the camera module of the electronic device according to an embodiment.

In an embodiment, the image sensor 442 may be disposed on the third surface 440a of the second circuit board 440. At least one second conductive region 445 may be formed on the fourth surface 440b of the second circuit board 440. The fourth surface 440b of the second circuit board 440 may at least partially face the first region (e.g., the first region 421 of FIG. 7) of the first circuit board (e.g., the first circuit board 420 of FIG. 7).

In an embodiment, the image sensor 442 may be disposed to overlap a second center point C2. For example, the second center point C2 of the second circuit board 440 may be a geometric center of the second circuit board 440. For example, the second center point C2 may be defined as the center of the second circuit board 440 in the X-axis direction and the Y-axis direction. In various embodiments, the second center point C2 may be a point through which a virtual line extending from the optical axis of the lens (e.g., the optical axis L of FIG. 5) passes in a state (e.g., the default state) in which the moving part 402 is not rotated.

In an embodiment, the second conductive region 445 may be formed in a position spaced apart from the second center point C2 of the second circuit board 440 by a second distance r2 in a radial direction. In various embodiments, second conductive regions 445-1, 445-2, 445-3, and 445-4 may have substantially the same radius when viewed based on a virtual circle having the second center point C2 as the center.

In an embodiment, the second conductive region 445 may include a conductive region 2-1 445-1, a conductive region 2-2 445-2, a conductive region 2-3 445-3, and a conductive region 2-4 445-4. According to an embodiment, the second circuit board 440 is not limited to including four second conductive regions and may include a plurality of (e.g., two, three, or five) second conductive regions 425.

In an embodiment, the conductive region 2-1 445-1 may be located in the +Y-axis direction with respect to the second center point C2. The conductive region 2-2 445-2 may be located in the +X-axis direction with respect to the second center point C2. The conductive region 2-3 445-3 may be located in the -Y-axis direction with respect to the second center point C2. The conductive region 2-4 425-4 may be located in the -X-axis direction with respect to the second center point C2.

In an embodiment, the second conductive regions 445-1, 445-2, 445-3, and 445-4 may be disposed at the same intervals. For example, one of the second conductive regions 445-1, 445-2, 445-3, and 445-4 may be spaced apart from another second conductive region adjacent thereto at substantially the same angle. For example, referring to the drawing, one of the second conductive regions 445-1, 445-2, 445-3, and 445-4 may be spaced apart from another second conductive region adjacent thereto at a second angle (e.g., 90 degrees). However, the angle between the second conductive regions 445-1, 445-2, 445-3, and 445-4 may vary depending on the number of second conductive regions 445 and is not limited to the second angle (e.g., 90 degrees).

In an embodiment, the second conductive region 445 of the second circuit board 440 may be electrically connected with the first conductive region (e.g., the first conductive region 425 of FIG. 7) of the first circuit board (e.g., the first circuit board 420 of FIG. 7).

For example, the conductive region 2-1 445-1 may be electrically connected with the conductive region 1-1 of the first circuit board 420 (e.g., the conductive region 1-1 425-1 of FIG. 7). For example, the conductive region 2-2 445-2 may be electrically connected with the conductive region 1-2 of the first circuit board 420 (e.g., the conductive region 1-2 425-2 of FIG. 7). For example, the conductive region 2-3 445-3 may be electrically connected with the conductive region 1-3 of the first circuit board 420 (e.g., the conductive region 1-3 425-3 of FIG. 7). For example, the conductive region 2-4 445-4 may be electrically connected with the conductive region 1-4 of the first circuit board 420 (e.g., the conductive region 1-4 425-4 of FIG. 7).

According to an embodiment, without being limited to those illustrated in the drawing, the positions and/or sizes of the second conductive regions 445-1, 445-2, 445-3, and 445-4 may be formed in various forms. For example, the second conductive regions 445-1, 445-2, 445-3, and 445-4 may be formed in various forms depending on the shape of the flexible substrate of the connecting structure (e.g., the connecting structure 500 of FIG. 5). For example, in a case in which a second conductive pad (e.g., a second conductive pad 602 of FIG. 18) is formed on a central region of a second flexible substrate (e.g., a second flexible substrate 620 of FIG. 18) as illustrated in FIG. 18, the second circuit board 440 may include second conductive regions corresponding to the position and/or size of the second conductive pad.

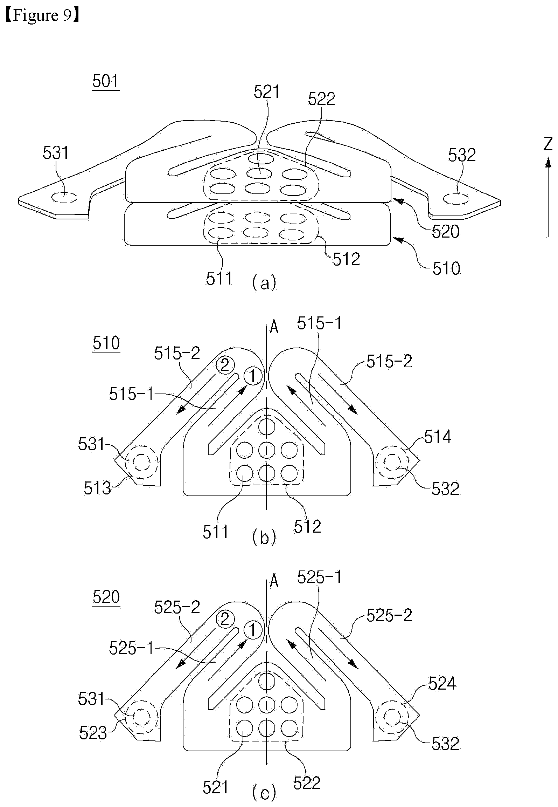

FIG. 9 is a view illustrating the connecting structure of the camera module of the electronic device according to an embodiment.

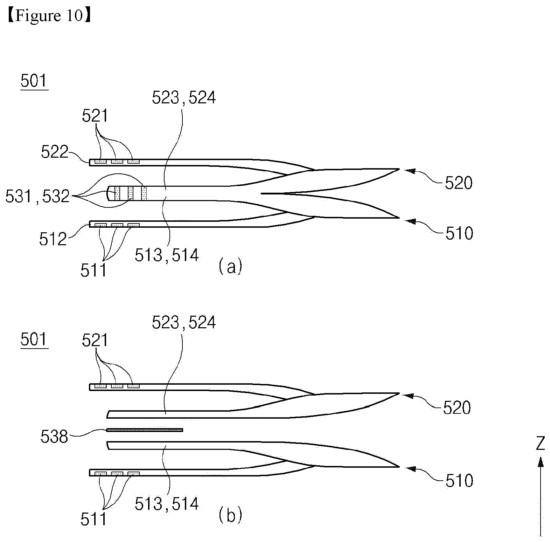

In an embodiment, the connecting structure (e.g., the connecting structure 500 of FIG. 6B) may include at least one flexible substrate 501. In an embodiment, the flexible substrate 501 may include a first portion 510, a second portion 520, VIAs 531 and 532, and an adhesive layer (e.g., an adhesive layer 538 of FIG. 10) that couples the first portion 510 and the second portion 520.

In an embodiment, the first portion 510 and the second portion 520 may be physically coupled through the VIAs 531 and 532 and the adhesive layer. For example, an adhesive material (e.g., an optical clear adhesive (OCA) or a pressure sensitive adhesive (PSA)) may be formed on first VIA regions 513 and 514 of the first portion 510 in which the VIAs 531 and 532 are formed and second VIA regions 523 and 524 of the second portion 520 in which the VIAs 531 and 532 are formed. In an embodiment, the first portion 510 and the second portion 520 may be electrically connected through the VIAs 531 and 532. For example, the VIAs 531 and 532 may be configured to electrically connect a first conductive pattern included in the first portion 510 and a second conductive pattern included in the second portion 520.

In an embodiment, the VIAs 531 and 532 may include the first VIA 531 located on one side of a first pad region 512 and a second pad region 522 (e.g., the left side based on the drawing) and the second VIA 532 located on an opposite side of the first pad region 512 and the second pad region 522 (e.g., the right side based on the drawing).

In an embodiment, the first portion 510 may include the first pad region 512 in which a first conductive pad 511 is formed, the first VIA regions 513 and 514 in which the VIAs 531 and 532 are formed, and first extension regions 515-1 and 515-2 extending from the first pad region 512 to the first VIA regions 513 and 514.

In an embodiment, the first VIA regions 513 and 514 may include the VIA region 1-1 513 in which the first VIA 531 is formed and the VIA region 1-2 514 in which the second VIA 532 is formed. The first pad region 512 may be located between the VIA region 1-1 513 and the VIA region 1-2 514.

In an embodiment, the first extension regions 515-1 and 515-2 may include the extension region 1-1 515-1 extending from the first pad region 512 in a direction (a direction ①) toward a center line A and the extension region 1-2 515-2 extending in a direction (a direction ②) away from the center line A. For example, the extension region 1-1 515-1 may be connected with the first pad region 512. For example, the extension region 1-2 515-2 may be connected with the VIA region 1-1 513 and the VIA region 1-2 514.

In an embodiment, the second portion 520 may include the second pad region 522 in which a second conductive pad 522 is formed, the second VIA regions 523 and 524 in which the VIAs 531 and 532 are formed, and second extension regions 525-1 and 525-2 extending from the second pad region 522 to the second VIA regions 523 and 524.

In an embodiment, the second VIA regions 523 and 524 may include the VIA region 2-1 523 in which the first VIA 531 is formed and the VIA region 2-2 524 in which the second VIA 532 is formed. The second pad region 522 may be located between the VIA region 2-1 523 and the VIA region 2-2 524.

In an embodiment, the second extension regions 525-1 and 525-2 may include the extension region 2-1 525-1 extending from the second pad region 522 in the direction (the direction ①) toward the center line A and the extension region 2-2 525-2 extending in the direction (the direction ②) away from the center line A. For example, the extension region 2-1 525-1 may be connected with the second pad region 522. For example, the extension region 2-2 525-2 may be connected with the VIA region 2-1 523 and the VIA region 2-2 524.

In an embodiment, the first extension regions 515-1 and 515-2 and/or the second extension regions 525-1 and 525-2 are illustrated in a shape bent once. However, without being limited thereto, the first extension regions 515-1 and 515-2 and/or the second extension regions 525-1 and 525-2 may be formed in a shape bent a plurality of times (e.g., three times). For example, a plurality of first extension regions 515-1 and 515-2 and/or a plurality of second extension regions 525-1 and 525-2 may be sequentially disposed to electrically connect the first pad region 512 and/or the second pad region 522 with the first VIA regions 513 and 514 and/or the second VIA regions 523 and 524.

In an embodiment, in the case in which the plurality of first extension regions 515-1 and 515-2 and/or the plurality of second extension regions 525-1 and 525-2 are formed, the first extension regions 515-1 and 515-2 and/or the second extension regions 525-1 and 525-2 may have different lengths. For example, the first extension regions 515-1 and 515-2 and/or the second extension regions 525-1 and 525-2 may have a gradually increasing length toward the first VIA regions 513 and 514 and/or the second VIA regions 523 and 524 in the first pad region 512 and/or the second pad region 522.

In the illustrated embodiment, the center line A may be defined on the flexible substrate 501. For example, the center line A may be defined as a virtual line extending from the edge regions of the first circuit board 420 and the second circuit board 440 illustrated in FIGS. 7 and 8 toward the first center point C1 and the second center point C2. In various embodiments, the center line A may pass through the first pad region 512 and the second pad region 522.

Referring to the drawing, the first pad region 512 may be formed in a symmetrical shape with respect to the center line A. In an embodiment, the first pad region 512 may be spaced apart from the first VIA regions 513 and 514 by a predetermined gap. For example, the first pad region 512 may be located between the VIA region 1-1 513 and the VIA region 1-2 514. For example, the VIA region 1-1 513 and the VIA region 1-2 514 may have shapes substantially symmetrical to each other with respect to the center line A.

Referring to the drawing, the second pad region 522 may be formed in a symmetrical shape with respect to the center line A. In an embodiment, the second pad region 522 may be spaced apart from the second VIA regions 523 and 524 by a predetermined gap. For example, the second pad region 522 may be located between the VIA region 2-1 523 and the VIA region 2-2 524. For example, the VIA region 2-1 523 and the VIA region 2-2 524 may have shapes substantially symmetrical to each other with respect to the center line A.

In an embodiment, the first portion 510 and the second portion 520 may be configured such that the first pad region 512 and the second pad region 522 face each other, but are spaced apart from each other by a predetermined gap and the first VIA regions 513 and 514 and the second VIA regions 523 and 524 are coupled to each other. For example, the gap between the first portion 510 and the second portion 520 may increase toward the pad regions 512 and 522 from the VIA regions 513, 514, 523, and 524.

According to an embodiment, the first circuit board (e.g., the first circuit board 420 of FIG. 7) and the flexible substrate 501 may be formed of one circuit board. For example, referring to FIG. 6C together, the first circuit board 490 may include an RFPCB that includes a rigid first region 491 and a flexible connecting region (e.g., the connecting region 494 of FIG. 6C). For example, the flexible substrate 501 may include the connecting region 494.

FIG. 10 is a view illustrating the flexible substrate of the camera module of the electronic device according to an embodiment. FIG. 10 is a sectional view taken along the center line A illustrated in FIG. 9.

Referring to FIG. 10, the flexible substrate 501 may include the adhesive layer 538. For example, the adhesive layer 538 may be disposed between the first VIA regions 513 and 514 of the first portion 510 and the second VIA regions 523 and 524 of the second portion 520 of the flexible substrate 501 and may physically couple the first portion 510 and the second portion 520. The VIAs 531 and 532 may be formed through the first portion 510, the second portion 520, and the adhesive layer 538. The adhesive layer 538 may be formed by applying an adhesive material. For example, the VIAs 531 and 532 may include a partial region of the first portion 510, a partial region of the second portion 520, a VIA hole penetrating the adhesive layer 538, and a conductive material filling at least a portion of the VIA hole.

In an embodiment, the first pad region 512 and the second pad region 522 may face each other, but may be spaced apart from each other by a predetermined gap. The first VIA regions 513 and 514 and the second VIA regions 523 and 524 may be located between the first pad region 512 and the second pad region 522 when viewed based on the Z-axis.

In an embodiment, the first conductive pad 511 may be electrically connected with the first conductive region (e.g., the first conductive region 425 of FIG. 7) of the first circuit board (e.g., the first circuit board 420 of FIG. 7). For example, the first conductive pad 511 may be surface-mounted or disposed on the first conductive region 425 of the first circuit board 420.

In an embodiment, the second conductive pad 521 may be electrically connected with the second conductive region (e.g., the second conductive region 445 of FIG. 8) of the second circuit board (e.g., the second circuit board 440 of FIG. 8). For example, the second conductive pad 521 may be surface-mounted on the second conductive region 445 of the second circuit board 440.

In an embodiment, the VIAs 531 and 532 may electrically connect the first VIA regions 513 and 514 of the first portion 510 and the second VIA regions 523 and 524 of the second portion 520, and thus the first conductive region 425 of the first circuit board 420 and the second conductive region 445 of the second circuit board 440 may be electrically connected.

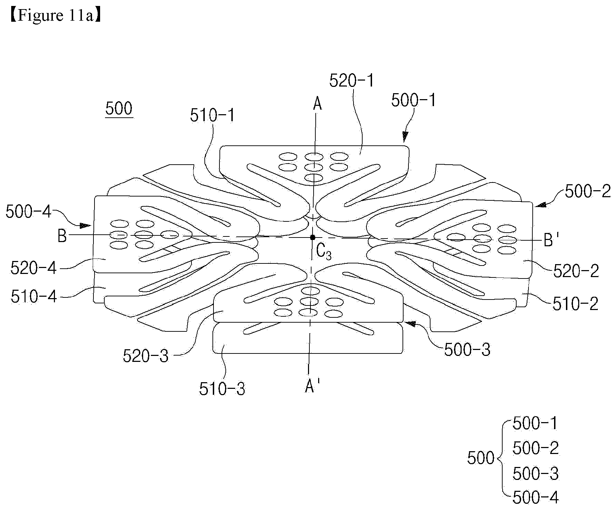

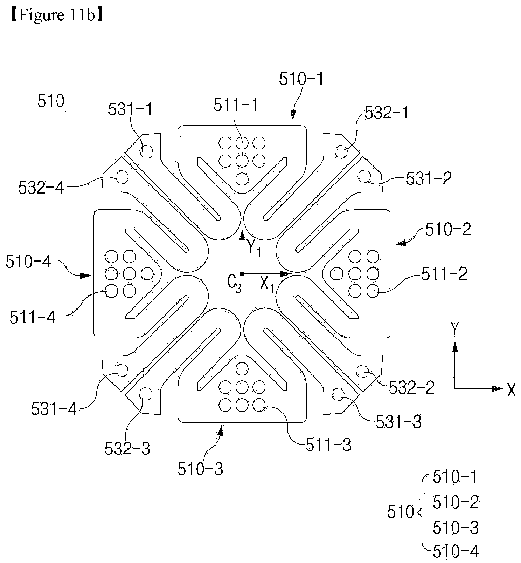

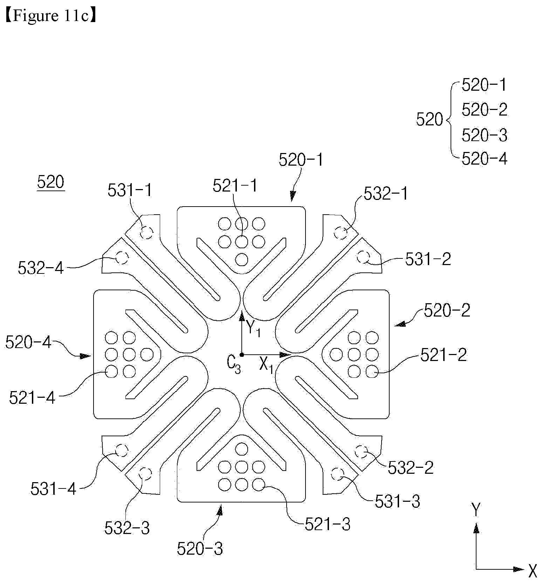

FIG. 11A is a view illustrating the connecting structure 500 of the camera module of the electronic device according to an embodiment. FIG. 11B is a plan view of the first portion 510 of the connecting structure 500 of the camera module of the electronic device according to an embodiment. FIG. 11C is a plan view of the second portion 520 of the connecting structure 500 of the camera module of the electronic device according to an embodiment.

In an embodiment, the connecting structure 500 may be a structure including a plurality of flexible substrates 500-1, 500-2, 500-3, and 500-4. Each of the plurality of flexible substrates may be referred to as the flexible substrate 501 described with reference to FIGS. 9 and 10. In an embodiment, the connecting structure 500 may be configured to electrically and/or physically connect the first circuit board 420 and the second circuit board 440. For example, the plurality of flexible substrates included in the connecting structure 500 may electrically connect the first conductive region 425 of the first circuit board 420 and the second conductive region 445 of the second circuit board 440.

Referring to FIG. 11, the connecting structure 500 may include the first flexible substrate 500-1, the second flexible substrate 500-2, the third flexible substrate 500-3, and the fourth flexible substrate 500-4. For example, the number of flexible substrates included in the connecting structure 500 is not limited to that illustrated in the drawing, and the camera module 400 may include various numbers of flexible substrates.

In an embodiment, a third center point C3 that is a geometric center may be defined in the connecting structure 500. For example, the third center point C3 may be the center of the connecting structure 500 in the X-axis direction and the Y-axis direction. For example, the third point C3 may be located in a space surrounded by the first flexible substrate 500-1, the second flexible substrate 500-2, the third flexible substrate 500-3, and the fourth flexible substrate 500-4.

In an embodiment, the plurality of flexible substrates 500-1, 500-2, 500-3, and 500-4 may be symmetrically disposed with respect to the third center point C3. For example, the first flexible substrate 500-1 and the third flexible substrate 500-3 may be formed in positions and/or shapes symmetrical to each other with respect to the axis X1 parallel to the direction of the X-axis passing through the third center point C3. For example, the second flexible substrate 500-2 and the fourth flexible substrate 500-4 may be formed in positions and/or shapes symmetrical to each other with respect to the axis Y1 parallel to the direction of the Y-axis passing through the third center point C3.

In an embodiment, one flexible substrate among the plurality of flexible substrates 500-1, 500-2, 500-3, and 500-4 may be spaced apart from another flexible substrate adjacent thereto by a predetermined gap. For example, the plurality of flexible substrates may be spaced apart from each other at a predetermined angle (e.g., about 90 degrees) when viewed with respect to the third center point C3.

In an embodiment, the plurality of flexible substrates 500-1, 500-2, 500-3, and 500-4 may be disposed such that conductive pads 511 and 521 included in the plurality of flexible substrates are located in a symmetric arrangement. For example, conductive pads 511-1 and 521-1 of the first flexible substrate 500-1 may be formed in positions and/or shapes symmetrical to conductive pads 511-3 and 521-3 of the third flexible substrate 500-3 with respect to the axis X1. For example, conductive pads 511-2 and 521-2 of the second flexible substrate 500-2 may be formed in positions and/or shapes symmetrical to conductive pads 511-4 and 521-4 of the fourth flexible substrate 500-4 with respect to the axis Y1.

In an embodiment, the first flexible substrate 500-1 may include a portion 1-1 510-1 and a portion 2-1 520-1. The portion 1-1 510-1 and the portion 2-1 520-1 may be coupled in regions around VIAs 531-1 and 532-1 (e.g., the VIA regions 513, 514, 523, and 524 of FIG. 9) and may be configured such that the conductive pad 1-1 511-1 and the conductive pad 2-1 521-1 are spaced apart from each other. In an embodiment, the VIAs 531-1 and 532-1 may include the VIA 1-1 531-1 located on one side of the conductive pad 1-1 511-1 and the conductive pad 2-1 521-1 and the VIA 2-1 532-1 located on an opposite side of the conductive pad 1-1 511-1 and the conductive pad 2-1 521-1. For example, when the X-Y plane is viewed from above, the VIA 1-1 531-1 may be located in the counterclockwise direction of the conductive pad 1-1 511-1 and the conductive pad 2-1 521-1 with respect to the third center point C3, and the VIA 2-1 532-1 may be located in the clockwise direction of the conductive pad 1-1 511-1 and the conductive pad 2-1 521-1 with respect to the third center point C3.

In an embodiment, the second flexible substrate 500-2 may include a portion 1-2 510-2 and a portion 2-2 520-2. The portion 1-2 510-2 and the portion 2-2 520-2 may be coupled in regions around VIAs 531-2 and 532-2 (e.g., the VIA regions 513, 514, 523, and 524 of FIG. 9) and may be configured such that the conductive pad 1-2 511-2 and the conductive pad 2-2 521-2 are spaced apart from each other. In an embodiment, the VIAs 531-2 and 532-2 may include the VIA 1-2 531-2 located on one side of the conductive pad 1-2 511-2 and the conductive pad 2-2 521-2 and the VIA 2-2 532-2 located on an opposite side of the conductive pad 1-2 511-2 and the conductive pad 2-2 521-2. For example, when the X-Y plane is viewed from above, the VIA 1-2 531-2 may be located in the counterclockwise direction of the conductive pad 1-2 511-2 and the conductive pad 2-2 521-2 with respect to the third center point C3, and the VIA 2-2 532-2 may be located in the clockwise direction of the conductive pad 1-2 511-2 and the conductive pad 2-2 521-2 with respect to the third center point C3.

In an embodiment, the third flexible substrate 500-3 may include a portion 1-3 510-3 and a portion 2-3 520-3. The portion 1-3 510-3 and the portion 2-3 520-3 may be coupled in regions around VIAs 531-3 and 532-3 (e.g., the VIA regions 513, 514, 523, and 524 of FIG. 9) and may be configured such that the conductive pad 1-3 511-3 and the conductive pad 2-3 521-3 are spaced apart from each other. In an embodiment, the VIAs 531-3 and 532-3 may include the VIA 1-3 531-3 located on one side of the conductive pad 1-3 511-3 and the conductive pad 2-3 521-3 and the VIA 2-3 532-3 located on an opposite side of the conductive pad 1-3 511-3 and the conductive pad 2-3 521-3. For example, when the X-Y plane is viewed from above, the VIA 1-3 531-3 may be located in the counterclockwise direction of the conductive pad 1-3 511-3 and the conductive pad 2-3 521-3 with respect to the third center point C3, and the VIA 2-3 532-3 may be located in the clockwise direction of the conductive pad 1-3 511-3 and the conductive pad 2-3 521-3 with respect to the third center point C3.

In an embodiment, the fourth flexible substrate 500-4 may include a portion 1-4 510-4 and a portion 2-4 520-4. The portion 1-4 510-4 and the portion 2-4 520-4 may be coupled in regions around VIAs 531-4 and 532-4 (e.g., the VIA regions 513, 514, 523, and 524 of FIG. 9) and may be configured such that the conductive pad 1-4 511-4 and the conductive pad 2-4 521-4 are spaced apart from each other. In an embodiment, the VIAs 531-4 and 532-4 may include the VIA 1-4 531-4 located on one side of the conductive pad 1-4 511-4 and the conductive pad 2-4 521-4 and the VIA 2-4 532-4 located on an opposite side of the conductive pad 1-4 511-4 and the conductive pad 2-4 521-4. For example, when the X-Y plane is viewed from above, the VIA 1-4 531-4 may be located in the counterclockwise direction of the conductive pad 1-4 511-4 and the conductive pad 2-4 521-4 with respect to the third center point C3, and the VIA 2-4 532-4 may be located in the clockwise direction of the conductive pad 1-4 511-4 and the conductive pad 2-4 521-4 with respect to the third center point C3.

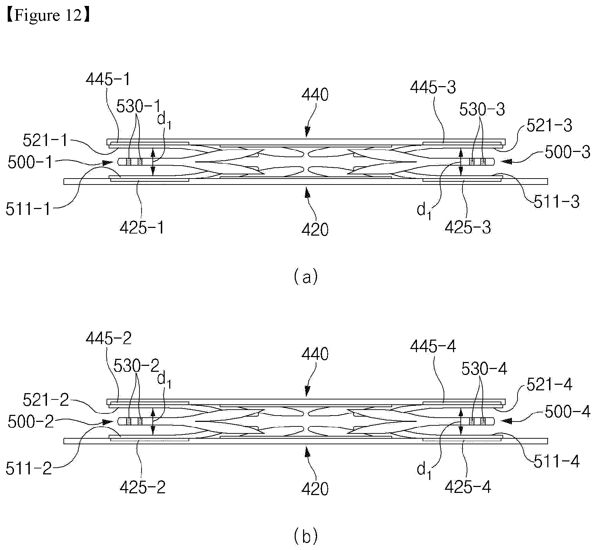

FIG. 12 is a view illustrating the connecting structure of the camera module of the electronic device according to an embodiment. (a) of FIG. 12 is a sectional view taken along line A-A' of FIG. 11, and (b) of FIG. 12 is a sectional view taken along line B-B' of FIG. 11.

In an embodiment, the first flexible substrate 500-1 may electrically connect the conductive region 1-1 425-1 of the first circuit board 420 and the conductive region 2-1 445-1 of the second circuit board 440. In an embodiment, the first conductive pad 511-1 of the first flexible substrate 500-1 may be electrically connected with the conductive region 1-1 425-1 of the first circuit board 420. In an embodiment, the second conductive pad 521-1 of the first flexible substrate 500-1 may be electrically connected with the conductive region 2-1 445-1 of the second circuit board 440.

In an embodiment, the second flexible substrate 500-2 may electrically connect the conductive region 1-2 425-2 of the first circuit board 420 and the conductive region 2-2 445-2 of the second circuit board 440. In an embodiment, the first conductive pad 511-2 of the second flexible substrate 500-2 may be electrically connected with the conductive region 1-2 425-2 of the first circuit board 420. In an embodiment, the second conductive pad 521-2 of the second flexible substrate 500-2 may be electrically connected with the conductive region 2-2 445-2 of the second circuit board 440.

In an embodiment, the third flexible substrate 500-3 may electrically connect the conductive region 1-3 425-3 of the first circuit board 420 and the conductive region 2-3 445-3 of the second circuit board 440. In an embodiment, the first conductive pad 511-3 of the third flexible substrate 500-3 may be electrically connected with the conductive region 1-3 425-3 of the first circuit board 420. In an embodiment, the second conductive pad 521-3 of the third flexible substrate 500-3 may be electrically connected with the conductive region 2-3 445-3 of the second circuit board 440.

In an embodiment, the fourth flexible substrate 500-4 may electrically connect the conductive region 1-4 425-4 of the first circuit board 420 and the conductive region 2-4 445-4 of the second circuit board 440. In an embodiment, the first conductive pad 511-4 of the fourth flexible substrate 500-4 may be electrically connected with the conductive region 1-4 425-4 of the first circuit board 420. In an embodiment, the second conductive pad 521-4 of the fourth flexible substrate 500-4 may be electrically connected with the conductive region 2-4 445-4 of the second circuit board 440.

The illustrated connecting structure 500 shows the default state in which the optical axis (e.g., the optical axis L of FIG. 5) of the lens (e.g., the lens 405 of FIG. 5) is substantially parallel to the Z-axis.

In the illustrated embodiment, the first conductive pad 511-1 and the second conductive pad 521-1 of the first flexible substrate 500-1 may form a first gap d1.

In the illustrated embodiment, the first conductive pad 511-2 and the second conductive pad 521-2 of the second flexible substrate 500-2 may form the first gap d1.

In the illustrated embodiment, the first conductive pad 511-3 and the second conductive pad 521-3 of the third flexible substrate 500-3 may form the first gap d1.

In the illustrated embodiment, the first conductive pad 511-4 and the second conductive pad 521-4 of the fourth flexible substrate 500-4 may form the first gap d1.

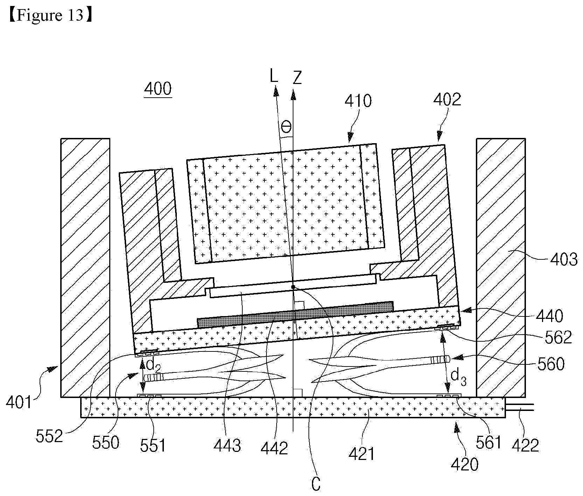

FIG. 13 is a view illustrating a rotation operation of the camera module 400 of the electronic device according to an embodiment. FIG. 13 is a view illustrating the connecting structure when the moving part 402 rotates about a rotational axis (e.g., the first rotational axis R1 and the second rotational axis R2 of FIG. 5) perpendicular to the optical axis L.

Referring to FIG. 13, at least a portion of the moving part 402 may be accommodated in the inner space of the fixed part 401. The moving part 402 may be configured to rotate about the center of rotation C (e.g., the center of rotation C of FIG. 5) to perform an image stabilization function. For example, the center of rotation C may be a point at which the optical axis L of the lens intersects a rotational axis (e.g., the rotational axes R1, R2, and R3 of FIG. 5). In an embodiment, the center of rotation may be formed in the moving part 402. In an embodiment, the center of rotation may be formed in the space between the moving part 402 and the fixed part 401.

In an embodiment, a lower surface of the moving part 402 may include the second circuit board 440. A lower surface of the fixed part 401 may include the first circuit board 420. At least a portion of the moving part 402 may be disposed in the fixed part 401 such that the first region 421 of the first circuit board 420 and the second circuit board 440 face each other. The moving part 402 may include the lens carrier 410 including the lens, the image sensor 442, and the infrared filter 443. The image sensor 442 may be disposed on the second circuit board 440. The moving part 402 may rotate relative to the fixed part 401 together with the lens carrier 410, the image sensor 442, the infrared filter 443, and the second circuit board 440. For example, the moving part 402 may move (e.g., rotate) relative to the fixed part 401 by a predetermined angle θ based on the Z-axis. In various embodiments, the predetermined angle θ may be less than 10 degrees.

In the illustrated embodiment, the camera module 400 may include a plurality of flexible substrates 550 and 560 disposed in the space between the first circuit board 420 and the second circuit board 440 to electrically connect the first circuit board 420 and the second circuit board 440. Referring to FIG. 13, the plurality of flexible substrate 550 and 560 may include the first flexible substrate 550 illustrated on the left side based on the drawing and the second flexible substrate 560 illustrated on the right side based on the drawing. For example, the first flexible substrate 550 may be referred to as the first flexible substrate 500-1 and/or the third flexible substrate 500-3 illustrated in FIGS. 11 and 12. For example, the second flexible substrate 560 may be referred to as the second flexible substrate 500-2 and/or the fourth flexible substrate 500-4 illustrated in FIGS. 11 and 12. In various embodiments, the first flexible substrate 550 and the second flexible substrate 560 illustrated in FIG. 13 may be referred to as one of the plurality of flexible substrates 500-1, 500-2, 500-3, and 500-4 illustrated in FIGS. 11 and 12 and another one thereof, respectively. In various embodiments, the first flexible substrate 550 and the second flexible substrate 560 may be flexible substrates disposed to be symmetrical to each other with the optical axis L or the Z-axis therebetween.

In the illustrated embodiment, the first flexible substrate 550 may include a first conductive pad 551 coupled to the first circuit board 420 and a second conductive pad 552 coupled to the second circuit board 440. In the illustrated embodiment, the second flexible substrate 560 may include a third conductive pad 561 coupled to the first circuit board 420 and a fourth conductive pad 562 coupled to the second circuit board 440. For example, the first conductive pad 551 and the third conductive pad 561 may be referred to as the first conductive pads 511-1, 511-2, 511-3, and 511-4 illustrated in FIGS. 11 and 12. For example, the second conductive pad 552 and the fourth conductive pad 562 may be referred to as the second conductive pads 521-1, 521-2, 521-3, and 521-4 illustrated in FIGS. 11 and 12.

The camera module 400 may include a first state (e.g., the default state) in which the optical axis L of the lens is parallel to the Z-axis and a second state (e.g., a rotated state) in which the optical axis L of the lens forms the predetermined angle θ with the Z-axis. FIG. 13 illustrates the camera module 400 in the rotated state. In various embodiments, the predetermined angle θ may be less than 10 degrees.

Referring to FIG. 13, in the rotated state, the first conductive pad 551 and the second conductive pad 552 of the first flexible substrate 550 may form a second gap d2. In the rotated state, the third conductive pad 561 and the fourth conductive pad 562 of the second flexible substrate 560 may form a third gap d3 different from the second gap d2. For example, the first circuit board 420 may be disposed to have a normal vector parallel to the Z-axis, and the second circuit board 440 may be disposed to have a normal vector parallel to the optical axis L. In an embodiment, one of the second gap d2 and the third gap d3 may be greater than the first gap (e.g., the first gap d1 of FIG. 12), and the other one of the second gap d2 and the third gap d3 may be smaller than the first gap (e.g., the first gap d1 of FIG. 12).

In an embodiment, the plurality of flexible substrates 550 and 560 may be formed to be deformable depending on the gap between the first circuit board 420 and the second circuit board 440 and may electrically connect the first circuit board 420 and the second circuit board 440 even when the moving part 402 moves.

In an embodiment, the image sensor 442 may be disposed between the second circuit board 440 and the flexible substrate 560. For example, a recess and/or hole (not illustrated) in which the image sensor 442 is disposed may be formed in at least a portion of the second circuit board 440, and the image sensor 442 may be disposed on at least a portion of the second circuit board 440. For example, the image sensor 442 may obtain light incident on a space (e.g., a recess and/or hole) formed in at least a portion of the second circuit board 440 and may convert the incident light signal into an electrical signal.

A camera module in the related art includes an FPCB that extends from a moving part to a printed circuit board (e.g., the printed circuit board 350 of FIG. 3) of an electronic device (e.g., the electronic device 300 of FIG. 3) located outside the camera module. One side of the FPCB may be coupled to the fixed printed circuit board 350, and therefore the tension of the FPCB may impede a movement of the moving part. To solve this problem, the camera module in the related art includes an FPCB having an increased length. Furthermore, the FPCB is configured to be bent a plurality of times in various directions so as to be located in a limited inner space of the mobile electronic device 300.

The connecting structure 500 of the camera module 400 according to an embodiment may be disposed in the space between the second circuit board 440 of the moving part 402 and the first circuit board 420 of the fixed part 401 (e.g., in the camera housing 403), and thus the size of the camera module 400 may be decreased. This may be more useful in the mobile electronic device 300 having a limited inner space.

Compared to the FPCB in the related art that extends outside the camera housing 403, the connecting structure 500 of the camera module 400 according to an embodiment may be located in a relatively narrow range from the center of rotation C of the moving part and may have a relatively small length. Accordingly, when the moving part 402 moves, repulsive force acting on the moving part 402 may be reduced. In addition, when the moving part 402 moves, a movement range of the connecting structure 500 may be decreased. As a result, current consumption required to move the moving part 402 may be decreased, and thus efficiency may be increased.

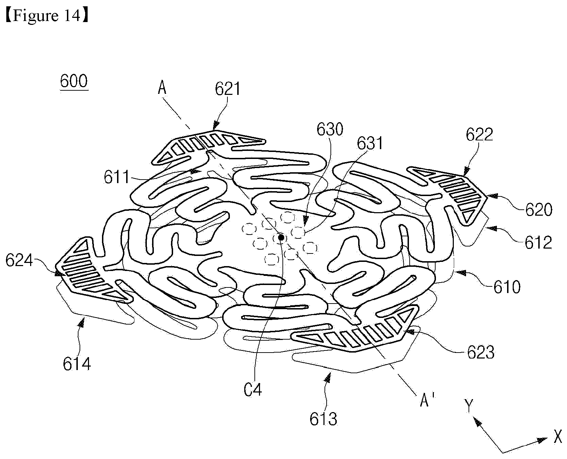

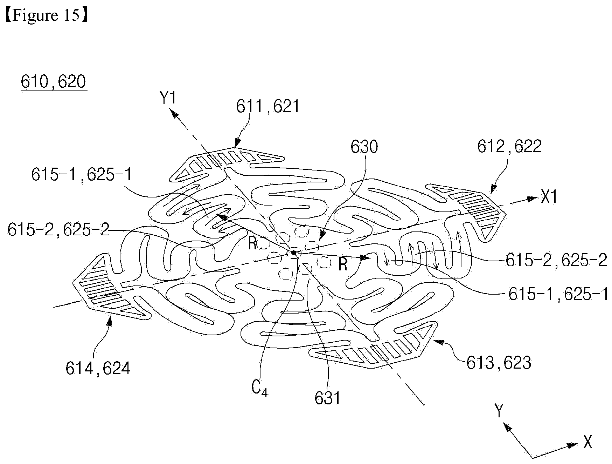

FIG. 14 is a view illustrating a connecting structure 600 of a camera module of the electronic device according to another embodiment. FIG. 15 is a view illustrating the connecting structure 600 of the camera module of the electronic device according to the other embodiment.

Referring to FIG. 14, the connecting structure 600 may include a first flexible substrate 610, a second flexible substrate 620, and a VIA 631. In an embodiment, the VIA 631 formed in a VIA region 630 may be formed through one region of the first flexible substrate 610 and one region of the second flexible substrate 620. In an embodiment, the VIA 631 may physically and/or electrically connect the first flexible substrate 610 and the second flexible substrate 620. In an embodiment, the first flexible substrate 610 may be coupled to the first circuit board 420, and the second flexible substrate 620 may be coupled to the second circuit board 440.

In the illustrated embodiment, a fourth center point C4 may be defined in the first flexible substrate 610 and the second flexible substrate 620. For example, the fourth center point C4 may be defined as a geometric center that is the center of the first flexible substrate 610 and the second flexible substrate 620 in the X-axis direction and the Y-axis direction. In an embodiment, the first flexible substrate 610 and the second flexible substrate 620 may be disposed to face each other.

Referring to FIG. 15, the first flexible substrate 610 may include first conductive pads 611, 612, 613, and 614 and first extension regions 615-1 and 615-2 extending from the VIA region 630 to the first conductive pads 611, 612, 613, and 614.

In an embodiment, the first flexible substrate 610 may include the conductive pad 1-1 611, the conductive pad 1-2 612, the conductive pad 1-3 613, and the conductive pad 1-4 614. In an embodiment, the first conductive pads 611, 612, 613, and 614 of the first flexible substrate 610 may be disposed at substantially the same distance from the fourth center point C4. In an embodiment, the conductive pad 1-1 611 may be disposed in the Y-axis direction, the conductive pad 1-2 612 may be disposed in the X-axis direction, the conductive pad 1-3 613 may be disposed in the -Y-axis direction, and the conductive pad 1-4 614 may be disposed in the -X-axis direction. In an embodiment, the conductive pad 1-1 611 and the conductive pad 1-3 613 may be disposed to be symmetrical to each other with respect to an axis X1 that is parallel to the X-axis and passes through the fourth center point C4. The conductive pad 1-2 612 and the conductive pad 1-4 614 may be disposed to be symmetrical to each other with respect to an axis Y1 that is parallel to the Y-axis and passes through the fourth center point C4.

Referring to FIG. 7 together, the conductive pad 1-1 611 may be coupled to the conductive region 1-1 425-1 of the first circuit board 420, the conductive pad 1-2 612 may be coupled to the conductive region 1-2 425-2 of the first circuit board 420, the conductive pad 1-3 613 may be coupled to the conductive region 1-3 425-3 of the first circuit board 420, and the conductive pad 1-4 614 may be coupled to the conductive region 1-4 425-4 of the first circuit board 420.

In an embodiment, the second flexible substrate 620 may include second conductive pads 621, 622, 623, and 624 and second extension regions 625-1 and 625-2 extending from the VIA region 630 to the second conductive pads 621, 622, 623, and 624.

In an embodiment, the second flexible substrate 620 may include the conductive pad 2-1 621, the conductive pad 2-2 622, the conductive pad 2-3 623, and the conductive pad 2-4 624. In an embodiment, the second conductive pads 621, 622, 623, and 624 of the second flexible substrate 620 may be disposed at substantially the same distance from the fourth center point C4. In an embodiment, the conductive pad 2-1 621 may be disposed in the Y-axis direction, the conductive pad 2-2 622 may be disposed in the X-axis direction, the conductive pad 2-3 623 may be disposed in the -Y-axis direction, and the conductive pad 2-4 624 may be disposed in the -X-axis direction. In an embodiment, the conductive pad 2-1 621 and the conductive pad 2-3 623 may be disposed to be symmetrical to each other with respect to the axis X1 that is parallel to the X-axis and passes through the fourth center point C4. The conductive pad 2-2 622 and the conductive pad 2-4 624 may be disposed to be symmetrical to each other with respect to the axis Y1 that is parallel to the Y-axis and passes through the fourth center point C4.

Referring to FIG. 8 together, the conductive pad 2-1 621 may be coupled to the conductive region 2-1 445-1 of the second circuit board 440, the conductive pad 2-2 622 may be coupled to the conductive region 2-2 445-2 of the second circuit board 440, the conductive pad 2-3 623 may be coupled to the conductive region 2-3 445-3 of the second circuit board 440, and the conductive pad 2-4 624 may be coupled to the conductive region 2-4 445-4 of the second circuit board 440.

In an embodiment, the first conductive region 425 of the first circuit board 420 may be electrically connected with the second conductive region 445 of the second circuit board 440 through the first conductive pads 611, 612, 613, and 614, the VIA 631, and the second conductive pads 621, 622, 623, and 624 of the connecting structure 600.

In various embodiments, the first flexible substrate 610 and the second flexible substrate 620 may be physically coupled in a region around the VIA 631 (e.g., the VIA region 630) and may be configured such that the first conductive pads 611, 612, 613, and 614 and the second conductive pads 621, 622, 623, and 624 are spaced apart from each other.

In an embodiment, conductive patterns connecting the VIA 631 and the first conductive pads 611, 612, 613, and 614 may be formed in the first extension regions 615-1 and 615-2. In the illustrated embodiment, when a virtual circle having the fourth center point C4 as the center is defined, the first extension regions 615-1 and 615-2 may extend in a circumferential direction or a tangential direction. For example, the first extension regions 615-1 and 615-2 may include the first region 615-1 extending in a first rotational direction (e.g., the clockwise direction) with respect to the fourth center point C4 and the second region 615-2 extending in a second rotational direction (e.g., the counterclockwise direction) opposite to the first rotational direction. For example, the first extension regions 615-1 and 615-2 may be formed in a zigzag shape in which one or more first regions 615-1 and one or more second regions 615-2 are alternately disposed. For example, the extension distances measured from the VIA region 630 to the first conductive pads 611, 612, 613, and 614 along the first extension regions 615-1 and 615-2 may be greater than the straight-line distances from the VIA region 630 to the first conductive pads 611, 612, 613, and 614. Accordingly, the first flexible substrate 610 may have a length to provide sufficient flexibility when the moving part 402 moves.

In an embodiment, conductive patterns connecting the VIA 631 and the second conductive pads 621, 622, 623, and 624 may be formed in the second extension regions 625-1 and 625-2. In the illustrated embodiment, when the virtual circle having the fourth center point C4 as the center is defined, the second extension regions 625-1 and 625-2 may extend in the circumferential direction or the tangential direction. For example, the second extension regions 625-1 and 625-2 may include the third region 625-1 extending in the first rotational direction (e.g., the clockwise direction) with respect to the fourth center point C4 and the fourth region 625-2 extending in the second rotational direction (e.g., the counterclockwise direction) opposite to the first rotational direction. For example, the second extension regions 625-1 and 625-2 may be formed in a zigzag shape in which one or more third regions 625-1 and one or more fourth regions 625-2 are alternately disposed. For example, the extension distances measured from the VIA region 630 to the second conductive pads 621, 622, 623, and 624 along the second extension regions 625-1 and 625-2 may be greater than the straight-line distances from the VIA region 630 to the second conductive pads 621, 622, 623, and 624. Accordingly, the second flexible substrate 620 may have a length to provide sufficient flexibility when the moving part 402 moves.

In an embodiment, the first flexible substrate 610 and the second flexible substrate 620 may be configured such that the gap increases from the VIA region 630, which is a central region, toward the conductive pads, which are edge regions.

Referring to the drawings, the first region 615-1 of the first extension regions 615-1 and 615-2 may be located closer to the fourth center point C4 than the second region 615-2. The third region 625-1 of the second extension regions 625-1 and 625-2 may be located closer to the fourth center point C4 than the fourth region 625-2. For example, the gap between the first region 615-1 and the third region 625-1 may be smaller than the gap between the second region 615-2 and the fourth region 625-2.

According to an embodiment, the shapes of the first extension regions 615-1 and 615-2 and the second extension regions 625-1 and 625-2 are not limited to the illustrated example and may be formed in various shapes. For example, the first extension regions may have a shape bent a plurality of times (e.g., a zigzag shape). For example, when the virtual circle having the fourth center point C4 as the center is defined, the first extension regions 615-1 and 615-2 may include a first region extending radially inward (e.g., in a direction toward the fourth center point C4) and a second region extending radially outward (e.g., in a direction away from the fourth center point C4). For example, when the virtual circle having the fourth center point C4 as the center is defined, the second extension regions 625-1 and 625-2 may include a third region extending radially inward (e.g., in a direction toward the fourth center point C4) and a fourth region extending radially outward (e.g., in a direction away from the fourth center point C4).

According to an embodiment, the first extension regions 615-1 and 615-2 or the second extension regions 625-1 and 625-2 may be asymmetrically formed with respect to the axes of symmetry X1 and Y1. For example, the first extension regions 615-1 and 615-2 and the second extension regions 625-1 and 625-2 located on one side of the axes of symmetry X1 and Y1 may extend in zigzags in the tangential direction or the circumferential direction, and the first extension regions and the second extension regions located on an opposite side of the axes of symmetry X1 and Y1 may radially extend in zigzags.

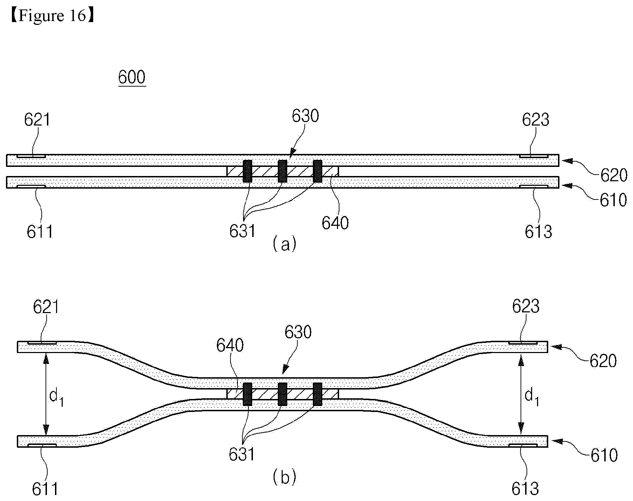

FIG. 16 is a view illustrating the connecting structure of the camera module of the electronic device according to the other embodiment. FIG. 16 is a sectional view taken along line A-A' illustrated in FIG. 14.

The conductive pad 1-1 611, the conductive pad 1-3 613, the conductive pad 2-1 621, and the conductive pad 2-3 623 are illustrated in FIG. 16. This may be substantially identically applied to the conductive pad 1-2 612, the conductive pad 1-4 614, the conductive pad 2-2 622, and the conductive pad 2-4 624 of FIG. 16.

In an embodiment, the connecting structure 600 may include the first flexible substrate 610, the second flexible substrate 620, an adhesive layer 640, and the VIA 631. The adhesive layer 640 may be disposed between the first flexible substrate 610 and the second flexible substrate 620. The VIA 631 may be formed through the first flexible substrate 610, the second flexible substrate 620, and the adhesive layer 640.

In an embodiment, the first flexible substrate 610 may have the conductive pad 1-1 611 and the conductive pad 1-3 613 formed on an edge region thereof and the VIA 631 formed in a central region thereof. In an embodiment, the second flexible substrate 620 may have the conductive pad 2-1 621 and the conductive pad 2-3 623 formed on an edge region thereof and the VIA 631 formed in a central region thereof. In an embodiment, the connecting structure 600 may be configured such that the conductive pad 1-1 611 and the conductive pad 2-1 621 face each other. In an embodiment, the connecting structure 600 may be configured such that the conductive pad 1-3 613 and the conductive pad 2-3 623 face each other.

In an embodiment, when the connecting structure 600 is coupled to the first circuit board 420 and the second circuit board 440, the conductive pad 1-1 611 and the conductive pad 2-1 621 may be spaced apart from each other by a first gap d1, and the conductive pad 1-3 613 and the conductive pad 2-3 623 may be spaced apart from each other by the first gap d1.

The illustrated connecting structure 600 shows a default state in which the optical axis (e.g., the optical axis L of FIG. 5) of the lens (e.g., the lens 405 of FIG. 5) is parallel to the Z-axis. In various embodiments, the first conductive pads 611 and 613 and the second conductive pads 621 and 623 may form the first gap d1 in the default state.

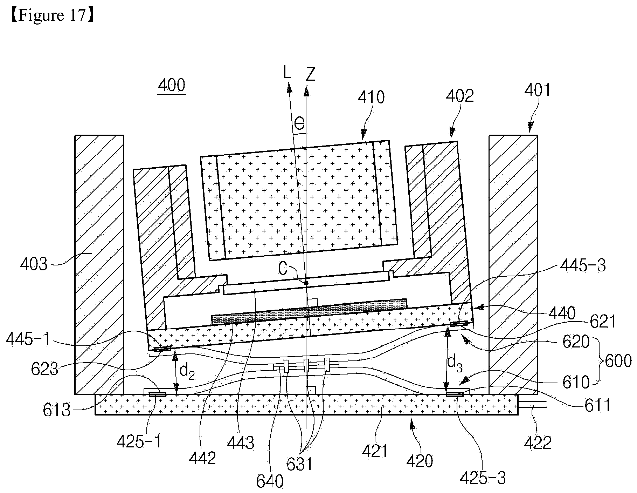

FIG. 17 is a view illustrating a rotation operation of the camera module of the electronic device according to the other embodiment. FIG. 17 is a view illustrating the connecting structure when the moving part rotates about a rotational axis (e.g., the first rotational axis R1 and the second rotational axis R2 of FIG. 5) perpendicular to the optical axis.

The conductive pad 1-1 611, the conductive pad 1-3 613, the conductive pad 2-1 621, and the conductive pad 2-3 623 are illustrated in FIG. 17. This may be substantially identically applied to the conductive pad 1-2 612, the conductive pad 1-4 614, the conductive pad 2-2 622, and the conductive pad 2-4 624 of FIG. 16.

Referring to FIG. 17, at least a portion of the moving part 402 may be accommodated in the inner space of the fixed part 401. The moving part 402 may be configured to rotate about the center of rotation C to perform an image stabilization function. For example, the center of rotation may be a point at which the optical axis L of the lens intersects a rotational axis (e.g., the rotational axes R1, R2, and R3 of FIG. 5). In an embodiment, the center of rotation may be formed in the moving part 402. Alternatively, the center of rotation may be formed in the space between the moving part 402 and the fixed part 401.

In an embodiment, the lower surface of the moving part 402 may include the second circuit board 440. The lower surface of the fixed part 401 may include the first circuit board 420. The moving part 402 may be disposed in the fixed part 401 such that the first region 421 of the first circuit board 420 and the second circuit board 440 face each other. The moving part 402 may include the lens carrier 410 including the lens, the image sensor 442, and the infrared filter 443. The image sensor may be disposed on the second circuit board. The moving part 402 may rotate relative to the fixed part 401 together with the lens carrier 410, the image sensor 442, the infrared filter 443, and the second circuit board 440.

In an embodiment, the conductive pad 1-1 611 of the first flexible substrate 610 may be coupled to the conductive region 1-1 425-1 of the first circuit board 420, and the conductive pad 1-3 613 may be coupled to the conductive region 1-3 425-3 of the first circuit board 420. In an embodiment, the conductive pad 2-1 621 of the second flexible substrate 620 may be coupled to the conductive region 2-1 445-1 of the second circuit board 440, and the conductive pad 2-3 623 may be coupled to the conductive region 2-3 445-3 of the second circuit board 440. In an embodiment, the first circuit board 420 and the second circuit board 440 may be electrically connected through the first conductive pads 611 and 613, the second conductive pads 621 and 623, and the VIA 631.

For example, the images sensor 442 may be configured to convert an incident light signal into an electrical signal. The image sensor 442 may be electrically connected to the second circuit board 440. For example, the electrical signal may be transmitted to the first circuit board 420 through the second conductive regions 445-1 and 445-3 of the second circuit board 440, and the second conductive pads 621 and 623, the VIA 631, and the first conductive pads 611 and 613 of the connecting structure 600. The electrical signal may be transmitted to the printed circuit board (e.g., the printed circuit board 350 of FIG. 3C) of the electronic device (e.g., the electronic device 300 of FIGS. 3A to 3C) through the second region 422 of the first circuit board 420.

Referring to FIG. 17, in a rotated state, the conductive pad 1-1 611 and the conductive pad 2-1 621 may form a second gap d2. In the rotated state, the conductive pad 1-3 613 and the conductive pad 2-3 623 may form a third gap d3 different from the second gap d2. In various embodiments, one of the second gap and the third gap d3 may be greater than the first gap (e.g., the first gap d1 of FIG. 16), and the other one of the second gap and the third gap d3 may be smaller than the first gap d1.

In an embodiment, the connecting structure 600 may be formed to be deformable depending on the gap between the first circuit board 420 and the second circuit board 440 and may electrically connect the first circuit board 420 and the second circuit board 440 even when the moving part 402 moves.

FIG. 18 is a view illustrating a connecting structure of a camera module of the electronic device according to various embodiments.

Referring to FIG. 18, the connecting structure may include a first flexible substrate 610, a second flexible substrate 620, an adhesive layer 640, and a VIA 603.

In an embodiment, the first flexible substrate 610 may include a first conductive pad 601 formed on a central region thereof. The first flexible substrate 610 may be coupled to the first circuit board 420 such that the first conductive pad 601 is electrically connected with the first conductive region 425 of the first circuit board 420.

In an embodiment, the second flexible substrate 620 may include a second conductive pad 602 formed on a central region thereof. The second flexible substrate 620 may be coupled to the second circuit board 440 such that the second conductive pad 602 is electrically connected with the second conductive region 445 of the second circuit board 440.

In an embodiment, the adhesive layer 640 may be disposed between an edge region of the first flexible substrate 610 and an edge region of the second flexible substrate 620. In an embodiment, the VIA 603 may penetrate the edge region of the first flexible substrate 610 and the edge region of the second flexible substrate 620. The VIA 603 may penetrate the adhesive layer 640.

In an embodiment, when the connecting structure 600 is coupled to the first circuit board 420 and the second circuit board 440, the first conductive pad 601 and the second conductive pad 602 may be spaced apart from each other by a predetermined gap. In the illustrated embodiment, the first flexible substrate 610 and the second flexible substrate 620 may make contact with each other at the edge regions through the VIA 603 and may be spaced apart from each other at the central regions.

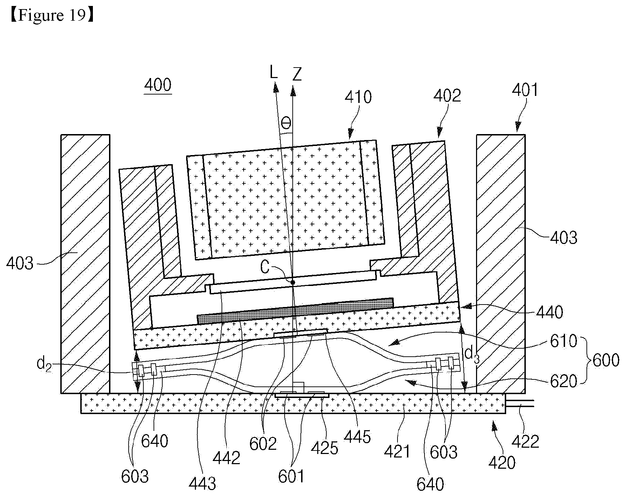

FIG. 19 is a view illustrating a rotation operation of the camera module of the electronic device according to various embodiments. FIG. 19 is a view illustrating the connecting structure when the moving part rotates about a rotational axis (e.g., the first rotational axis R1 and the second rotational axis R2 of FIG. 5) perpendicular to the optical axis.

In an embodiment, the lower surface of the moving part 402 may include the second circuit board 440. The lower surface of the fixed part 401 may include the first circuit board 420. The moving part 402 may be disposed in the fixed part 401 such that the first region 421 of the first circuit board 420 and the second circuit board 440 face each other. The moving part 402 may include the lens carrier 410 including the lens, the image sensor 442, and the infrared filter 443. The image sensor may be disposed on the second circuit board. The moving part 402 may rotate relative to the fixed part 401 together with the lens carrier 410, the image sensor 442, the infrared filter 443, and the second circuit board 440.

In an embodiment, the first conductive pad 601 of the first flexible substrate 610 may be coupled to the conductive region 425 of the first circuit board 420. In an embodiment, the second conductive pad 602 of the second flexible substrate 620 may be coupled to the second conductive region 445 of the second circuit board 440. In an embodiment, the VIA 603 may be located in the space between the first circuit board 420 and the second circuit board 440.

In an embodiment, the first circuit board 420 and the second circuit board 440 may be electrically connected through the first conductive pad 601, the second conductive pad 602, and the VIA 603. For example, an electrical signal generated from the image sensor 442 may be transmitted to the first circuit board 420 through the second conductive region 445 of the second circuit board 440, and the second conductive pad 602, the VIA 603, and the first conductive pad 601 of the connecting structure. The electrical signal may be transmitted to the printed circuit board (e.g., the printed circuit board 350 of FIG. 3C) of the electronic device (e.g., the electronic device 300 of FIGS. 3A to 3C) through the second region 422 of the first circuit board 420.

Referring to FIG. 19, in a rotated state, first edges of the first circuit board 420 and the second circuit board 440 (e.g., left sides based on the drawing) may be spaced apart from each other by a second gap d2, and second edges of the first circuit board 420 and the second circuit board 440 (e.g., right sides based on the drawing) may be spaced apart from each other by a third gap d3 different from the second gap d2. For example, the connecting structure 600 may be deformed depending on a change in the gap between the first circuit board 420 and the second circuit board 440. According to an embodiment, the connecting structure 600 may electrically connect the first circuit board 420 and the second circuit board 440 even when the moving part 402 moves.

An electronic device 300 according embodiments of the disclosure may include a housing 310 and a camera module 400, at least a portion of which is disposed in the housing 310. The camera module 400 may include a fixed part 401 including a first circuit board 420, a moving part 402 including a lens 405, an image sensor 442, and a second circuit board 440 that is electrically connected with the image sensor 442 and that faces at least a portion of the first circuit board 420, the moving part 402 being at least partially accommodated in the fixed part 401 and coupled to the fixed part 401 so as to be rotatable, and a connecting structure 500 that is disposed between the first circuit board 420 and the second circuit board 440 and that includes a flexible substrate 501 that electrically connects the first circuit board 420 and the second circuit board 440. The flexible substrate 501 may include a first portion 510 including a first conductive pad 511 coupled with a first conductive region 425 of the first circuit board 420, a second portion 520 including a second conductive pad 521 coupled with a second conductive region 445 of the second circuit board 440, and at least one VIA 531 and 532 that electrically connects the first portion 510 and the second portion 520.

In various embodiments, the first portion 510 and the second portion 520 may be formed in substantially the same shape.

In various embodiments, the flexible substrate 501 may be at least partially hidden by the second circuit board 440 when the second circuit board 440 is viewed in a direction of an optical axis of the lens 405.

In various embodiments, the first portion 510 may include a first pad region 512 in which the first conductive pad 511 is formed, a first VIA region 513 and 514 in which the VIA 531 and 532 is formed, and a first extension region 515 that extends from the first pad region 512 to the first VIA region 513 and 514. The second portion 520 may include a second pad region 522 in which the second conductive pad 521 is formed, a second VIA region 523 and 524 in which the VIA 531 and 532 is formed, and a second extension region 525 that extends from the second pad region 522 to the second VIA region 523 and 524. The flexible substrate 501 may further include an adhesive layer 538 disposed between the first VIA region 513 and 514 and the second VIA region 523 and 524, and the VIA 531 and 532 may pass through the first VIA region 513 and 514, the second VIA region 523 and 524, and the adhesive layer 538.

In various embodiments, the first extension region 515 may include an extension region 1-1 515-1 that extends from the first pad region 512 in a first direction and an extension region 1-2 515-2 that extends in a second direction opposite to the first direction. The second extension region 525 may include an extension region 2-1 525-1 that extends from the second pad region 522 in the first direction and an extension region 2-2 525-2 that extends in the second direction opposite to the first direction.

In various embodiments, a space in which the at least one flexible substrate 501 is disposed may be formed between the first circuit board 420 and the second circuit board 440, and a center line extending from an optical axis of the lens 405 may be defined in the space. The extension region 1-1 515-1 and the extension region 2-1 525-1 may extend in a direction toward the center line, and the extension region 1-2 515-2 and the extension region 2-2 525-2 may extend in a direction away from the center line.

In various embodiments, the flexible substrate 501 may include a VIA region 513, 514, 523, and 524 in which the VIA 531 and 532 is formed, a first pad region 512 in which the first conductive pad 511 is formed, and a second pad region 522 in which the second conductive pad 521 is formed. The VIA region may include a first VIA region 513 and 523 spaced apart from one side of the first pad region 512 and the second pad region 522 and a second VIA region 514 and 524 spaced apart from an opposite side of the first pad region 512 and the second pad region 522.

In various embodiments, a center line extending from an optical axis of the lens 405 may be defined in the connecting structure 500, and the first VIA region 513 and 523 and the second VIA region 514 and 524 may be spaced apart from the center line by substantially the same distance.

In various embodiments, the VIA 531 and 532 may be formed at a position spaced apart from each of the first circuit board 420 and the second circuit board 440 by a predetermined gap.

In various embodiments, the flexible substrate 501 may include a first flexible substrate 501 and a second flexible substrate 501, and the first flexible substrate 501 and the second flexible substrate 501 may be disposed such that a virtual line extending from an optical axis of the lens 405 passes between the first flexible substrate 501 and the second flexible substrate 501.

An electronic device 300 according to embodiments of the disclosure may include a housing 310 including a camera region and a camera module 400, at least a portion of which is disposed in the housing 310. The camera module 400 may include a fixed part 401 including a camera housing 403 and a first circuit board 420 disposed in the camera housing, a moving part 402 including a lens 405, an image sensor 442 at least partially aligned with an optical axis of the lens 405, and a second circuit board 440 electrically connected with the image sensor 442, at least a portion of the moving part 402 being disposed in the fixed part 401, and the second circuit board 440 being disposed to at least partially face the first circuit board 420, and a first flexible substrate 500-1 and a second flexible substrate 500-2 that electrically connect the first circuit board 420 and the second circuit board 440. The first circuit board 420 may include a first conductive region 425-1 located at a first distance from an extension line of the optical axis of the lens 405 in a first direction perpendicular to the optical axis of the lens 405 and a second conductive region 425-2 located at the first distance in a second direction perpendicular to the optical axis of the lens 405. The second circuit board 440 may include a third conductive region 445-1 located at a second distance from the extension line of the optical axis of the lens in the first direction perpendicular to the optical axis of the lens and a fourth conductive region 445-2 located at the second distance in the second direction. The first flexible substrate 500-1 may be coupled to the first circuit board 420 and the second circuit board 440 to electrically connect the first conductive region and the third conductive region 445-1. The second flexible substrate 500-2 may be coupled to the first circuit board 420 and the second circuit board 440 to electrically connect the second conductive region 425-2 and the fourth conductive region 445-2.

In various embodiments, the first circuit board 420 and the second circuit board 440 may be configured such that the first conductive region 425-1 and the third conductive region 445-1 are spaced apart from each other by a predetermined gap and face each other and the second conductive region 425-2 and the fourth conductive region 445-2 are spaced apart from each other by a predetermined gap and face each other.

In various embodiments, the first distance and the second distance may be substantially the same as each other.

In various embodiments, each of the first flexible substrate 500-1 and the second flexible substrate 500-2 may include a first portion 510 including a first conductive pad 511 connected with the first conductive region 425-1, a second portion 520 including a second conductive pad 521 connected with the third conductive region 445-1, an adhesive layer 539 disposed between a partial region of the first portion 510 and a partial region of the second portion 520, and a VIA 531 and 532 that penetrates the adhesive layer 538 to electrically connect the first conductive pad 511 and the second conductive pad 521.

In various embodiments, the VIA 531 and 532 may be located between the first conductive region 425-1 and the second conductive region 425-2 when the first circuit board 420 is viewed in a direction of the optical axis of the lens 405.

In various embodiments, each of the first flexible substrate 500-1 and the second flexible substrate 500-2 may include an extension region 515 and 525 that extends from each of the first conductive pad 511 and the second conductive pad 521 to the VIA 531 and 532. The extension region 515 and 525 may include a first extension region 515-1 and 525-1 that extends in a direction toward the extension line of the optical axis of the lens 405 and a second extension region 515-2 and 525-2 that extends in a direction away from the extension line of the optical axis of the lens 405.

A camera module 400 according to embodiments of the disclosure may include a camera housing 403, a camera assembly including a lens 405, an image sensor 442 at least partially aligned with an optical axis of the lens 405, and a first circuit board 420 electrically connected with the image sensor 442, a second circuit board 440 disposed in the camera housing 403 such that at least a portion faces the first circuit board 420, a first flexible substrate 610 that is disposed between the first circuit board 420 and the second circuit board 440 and that includes a first conductive pad 601, 611, and 613 electrically connected with the first circuit board 420, a first central region and a first edge region that surrounds the first central region being defined in the first flexible substrate 610, a second flexible substrate 620 that is disposed between the first circuit board 420 and the second circuit board 440 and that includes a second conductive pad 602, 621, and 623 electrically connected with the second circuit board 440, a second central region aligned with the first central region and a second edge region aligned with the first edge region being defined in the second flexible substrate 620, and a VIA 603 and 631 that penetrates the first flexible substrate 610 and the second flexible substrate 620 to electrically connect the first flexible substrate 610 and the second flexible substrate 620. The first flexible substrate 610 and the second flexible substrate 620 may be configured such that the first conductive pad 601, 611, and 613 is formed in the first edge region, the second conductive pad 602, 621, and 623 is formed in the second edge region, and the VIA 603 and 631 is formed to penetrate the first central region and the second central region, or the first conductive pad 601, 611, and 613 is formed in the first central region, the second conductive pad 602, 621, and 623 is formed in the second central region, and the VIA 603 and 631 is formed to penetrate the first edge region and the second edge region.

In various embodiments, the first flexible substrate 610 may include a first extension region 615-1 and 615-2 including a first conductive pattern that extends from the VIA 603 and 631 to the first conductive pad 601, 611, and 613, and the second flexible substrate 620 may include a second extension region 625-1 and 625-2 including a second conductive pattern that extends from the VIA 603 and 631 to the second conductive pad 602, 621, and 623.

In various embodiments, a virtual line vertically passing through the first central region and the second central region and a virtual circle having the virtual line as a center may be defined in at least one of the first flexible substrate 610 or the second flexible substrate 620. At least one of the first extension region or the second extension region may include a first region 615-1 and 625-1 that substantially extends from at least one of the first central region or the second central region in a first circumferential direction or a first tangential direction of the virtual circle and a second region 615-2 and 625-2 that substantially extends in a second circumferential direction or a second tangential direction of the virtual circle.

In various embodiments, heights of the first region 615-1 and 625-1 and the second region 615-2 and 625-2 may be sequentially increased or decreased away from the virtual line.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

In various embodiments of this document, "adapted to or configured to" may be used interchangeably with "adapted to," "having the ability to," "modified to," "made to," "capable of," or "designed to," in terms of hardware or software depending on circumstances. In some contexts, the expression "device configured to" can mean that the device is "capable of" in conjunction with other devices or components. For example, the phrase "a processor configured to perform A, B, and C" may refer to a dedicated processor (eg, an embedded processor) for performing the corresponding operations, or a general-purpose processor (eg, CPU or AP) capable of performing the corresponding operations by executing one or more programs stored in a memory device (eg, memory 130)..

As used herein, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor(e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101, 300) comprising:
a housing (310); and
a camera module (180, 312, 400), at least a portion of which is disposed in the housing,
wherein the camera module includes:
a fixed part (401) including a first circuit board (420);
a moving part (402) including a lens (210, 405), an image sensor (230, 442), and a second circuit board (440) electrically connected with the image sensor and configured to face at least a portion of the first circuit board, the moving part being at least partially accommodated in the fixed part and coupled to the fixed part so as to be rotatable; and
a connecting structure (500) disposed between the first circuit board and the second circuit board, the connecting structure including a plurality of flexible substrates (501) configured to electrically connect the first circuit board and the second circuit board, and
wherein each flexible substrate of the plurality of flexible substrates includes a first portion (510, 610) including a first conductive pad (511, 601) coupled with a first conductive region (425) of the first circuit board, a second portion (520, 620) including a second conductive pad (521, 602) coupled with a second conductive region (445) of the second circuit board, and at least one VIA (531,532,603) configured to electrically connect the first portion and the second portion,
wherein the plurality of flexible substrates includes a first flexible substrate (500-1, 550) and a second flexible substrate (500-3, 560), and
wherein the first flexible substrate and the second flexible substrate are disposed to be symmetrical to each other with respect to an optical axis (L) of the lens.

2. The electronic device of claim 1, wherein the first portion and the second portion are formed in substantially the same shape.

3. The electronic device of claim 1, wherein the flexible substrate is at least partially hidden by the second circuit board when the second circuit board is viewed in a direction of the optical axis (L) of the lens.

4. The electronic device of claim 1, wherein the first portion includes a first pad region (512) in which the first conductive pad is formed, a first VIA region : (513, 514) in which the VIA (531,532) is formed, and a first extension region (515-1, 515-2) configured to extend from the first pad region to the first VIA region,
wherein the second portion includes a second pad region (522) in which the second conductive pad is formed, a second VIA region (523,524) in which the VIA is formed, and a second extension region (525-1, 525-2) configured to extend from the second pad region to the second VIA region,
wherein the flexible substrate further includes an adhesive layer (538) disposed between the first VIA region and the second VIA region, and
wherein the VIA passes through the first VIA region, the second VIA region, and the adhesive layer.

5. The electronic device of claim 4, wherein the first extension region includes an extension region 1-1 configured to extend from the first pad region in a first direction and an extension region 1-2 configured to extend in a second direction opposite to the first direction, and
wherein the second extension region includes an extension region 2-1 configured to extend from the second pad region in the first direction and an extension region 2-2 configured to extend in the second direction opposite to the first direction.

6. The electronic device of claim 5, wherein a space in which the one or more flexible substrates are disposed is formed between the first circuit board and the second circuit board,
wherein a center line extending from the optical axis of the lens is defined in the space,
wherein the extension region 1-1 and the extension region 2-1 extend in a direction toward the center line, and
wherein the extension region 1-2 and the extension region 2-2 extend in a direction away from the center line.

7. The electronic device of claim 1, wherein the flexible substrate includes plural of VIA regions (513, 523, 514, 524) in which the VIA (531,532) are formed, a first pad region (512) in which the first conductive pad is formed, and a second pad region (522) in which the second conductive pad is formed, and
wherein the plural VIA regions include a first VIA region (513,523) spaced apart from one side of the first pad region and the second pad region and a second VIA region (514, 524) spaced apart from an opposite side of the first pad region and the second pad region.

8. The electronic device of claim 7, wherein a center line extending from the optical axis of the lens is defined in the connecting structure, and
wherein the first VIA region and the second VIA region are spaced apart from the center line by substantially the same distance.

9. The electronic device of claim 1, wherein the VIA is formed at a position spaced apart from each of the first circuit board and the second circuit board by a predetermined gap.

10. The electronic device of claim 1, wherein the first flexible substrate and the second flexible substrate are disposed such that a virtual line extending from the optical axis of the lens passes between the first flexible substrate and the second flexible substrate.

## Patentansprüche

1. Elektronische Vorrichtung (101, 300), die Folgendes umfasst:
ein Gehäuse (310); und
ein Kameramodul (180, 312, 400), von dem zumindest ein Teil in dem Gehäuse angeordnet ist,
wobei das Kameramodul Folgendes enthält:
einen festen Teil (401), der eine erste Leiterplatte (420) enthält;
einen beweglichen Teil (402), der eine Linse (210, 405), einen Bildsensor (230, 442) und eine zweite Leiterplatte (440) enthält, die mit dem Bildsensor elektrisch verbunden und so konfiguriert ist, dass sie zumindest einem Teil der ersten Leiterplatte zugewandt ist, wobei der bewegliche Teil zumindest teilweise in dem festen Teil untergebracht und mit dem festen Teil so gekoppelt ist, dass er drehbar ist; und
eine Verbindungsstruktur (500), die zwischen der ersten Leiterplatte und der zweiten Leiterplatte angeordnet ist, wobei die Verbindungsstruktur eine Vielzahl von flexiblen Substraten (501) enthält, die so konfiguriert sind, dass sie die erste Leiterplatte und die zweite Leiterplatte elektrisch verbinden, und
wobei jedes flexible Substrat der Vielzahl von flexiblen Substraten einen ersten Teil (510, 610), der ein erstes leitfähiges Pad (511, 601) enthält, das mit einem ersten leitfähigen Bereich (425) der ersten Leiterplatte gekoppelt ist, einen zweiten Teil (520, 620), der ein zweites leitfähiges Pad (521, 602) enthält, das mit einem zweiten leitfähigen Bereich (445) der zweiten Leiterplatte gekoppelt ist, und mindestens eine VIA (531,532,603) enthält, die so konfiguriert ist, dass sie den ersten Teil und den zweiten Teil elektrisch verbindet,
wobei die Vielzahl von flexiblen Substraten ein erstes flexibles Substrat (500-1, 550) und ein zweites flexibles Substrat (500-3, 560) enthalten, und
wobei das erste flexible Substrat und das zweite flexible Substrat so angeordnet sind, dass sie in Bezug auf eine optische Achse (L) der Linse symmetrisch zueinander sind.

2. Elektronische Vorrichtung nach Anspruch 1, wobei der erste Teil und der zweite Teil im Wesentlichen die gleiche Form aufweisen.

3. Elektronische Vorrichtung nach Anspruch 1, wobei das flexible Substrat zumindest teilweise durch die zweite Leiterplatte verdeckt ist, wenn die zweite Leiterplatte in Richtung der optischen Achse (L) der Linse betrachtet wird.

4. Elektronische Vorrichtung nach Anspruch 1, wobei der erste Teil einen ersten Pad-Bereich (512), in dem das erste leitfähige Pad gebildet ist, einen ersten VIA-Bereich (513, 514), in dem die VIA (531,532) gebildet ist, und einen ersten Erweiterungsbereich (515-1, 515-2) enthält, der so konfiguriert ist, dass er sich von dem ersten Pad-Bereich zu dem ersten VIA-Bereich erstreckt,
wobei der zweite Teil einen zweiten Pad-Bereich (522), in dem das zweite leitfähige Pad gebildet ist, einen zweiten VIA-Bereich (523,524), in dem die VIA gebildet ist, und einen zweiten Erweiterungsbereich (525-1, 525-2) enthält, der so konfiguriert ist, dass er sich von dem zweiten Pad-Bereich zu dem zweiten VIA-Bereich erstreckt,
wobei das flexible Substrat ferner eine Klebeschicht (538) enthält, die zwischen dem ersten VIA-Bereich und dem zweiten VIA-Bereich angeordnet ist, und
wobei die VIA durch den ersten VIA-Bereich, den zweiten VIA-Bereich und die Klebeschicht verläuft.

5. Elektronische Vorrichtung nach Anspruch 4, wobei der erste Erweiterungsbereich einen Erweiterungsbereich 1-1, der so konfiguriert ist, dass er sich von dem ersten Pad-Bereich in eine erste Richtung erstreckt, und einen Erweiterungsbereich 1-2 enthält, der so konfiguriert ist, dass er sich in eine zweite Richtung erstreckt, die der ersten Richtung entgegengesetzt ist, und
wobei der zweite Erweiterungsbereich einen Erweiterungsbereich 2-1, der so konfiguriert ist, dass er sich von dem zweiten Pad-Bereich in die erste Richtung erstreckt, und einen Erweiterungsbereich 2-2 enthält, der so konfiguriert ist, dass er sich in die zweite Richtung erstreckt, die der ersten Richtung entgegengesetzt ist.

6. Elektronische Vorrichtung nach Anspruch 5, wobei zwischen der ersten Leiterplatte und der zweiten Leiterplatte ein Raum gebildet ist, in dem das eine oder die mehreren flexiblen Substrate angeordnet sind,
wobei in dem Raum eine Mittellinie definiert ist, die sich von der optischen Achse der Linse erstreckt,
wobei sich der Erweiterungsbereich 1-1 und der Erweiterungsbereich 2-1 in Richtung der Mittellinie erstrecken, und
wobei sich der Erweiterungsbereich 1-2 und der Erweiterungsbereich 2-2 in eine von der Mittellinie wegweisende Richtung erstrecken.

7. Elektronische Vorrichtung nach Anspruch 1, wobei das flexible Substrat mehrere VIA-Bereiche (513, 523, 514, 524), in denen die VIA (531,532) gebildet sind, einen ersten Pad-Bereich (512), in dem das erste leitfähige Pad gebildet ist, und einen zweiten Pad-Bereich (522) enthält, in dem das zweite leitfähige Pad gebildet ist, und
wobei die mehreren VIA-Bereiche einen ersten VIA-Bereich (513,523), der von einer Seite des ersten Pad-Bereichs und des zweiten Pad-Bereichs beabstandet ist, und einen zweiten VIA-Bereich (514, 524) enthalten, der von einer gegenüberliegenden Seite des ersten Pad-Bereichs und des zweiten Pad-Bereichs beabstandet ist.

8. Elektronische Vorrichtung nach Anspruch 7, wobei eine Mittellinie, die sich von der optischen Achse der Linse erstreckt, in der Verbindungsstruktur definiert ist, und
wobei der erste VIA-Bereich und der zweite VIA-Bereich von der Mittellinie um im Wesentlichen den gleichen Abstand beabstandet sind.

9. Elektronische Vorrichtung nach Anspruch 1, wobei die VIA an einer Position gebildet ist, die von der ersten Leiterplatte und der zweiten Leiterplatte jeweils durch einen vorgegebenen Spalt beabstandet ist.

10. Elektronische Vorrichtung nach Anspruch 1, wobei das erste flexible Substrat und das zweite flexible Substrat so angeordnet sind, dass eine virtuelle Linie, die sich von der optischen Achse der Linse erstreckt, zwischen dem ersten flexiblen Substrat und dem zweiten flexiblen Substrat verläuft.

## Revendications

1. Dispositif électronique (101, 300) comprenant :
un boîtier (310) ; et
un module de caméra (180, 312, 400), dont au moins une portion est disposée dans le boîtier,
où le module de caméra inclut :
une partie fixe (401) incluant une première carte de circuit imprimé (420) ;
une partie mobile (402) incluant une lentille (210, 405), un capteur d'image (230, 442), et une deuxième carte de circuit imprimé (440) connectée électriquement au capteur d'image et configurée pour faire face à au moins une portion de la première carte de circuit imprimé, la partie mobile étant au moins partiellement logée dans la partie fixe et couplée à la partie fixe de manière à pouvoir tourner ; et
une structure de connexion (500) disposée entre la première carte de circuit imprimé et la deuxième carte de circuit imprimé, la structure de connexion incluant une pluralité de substrats flexibles (501) configurés pour connecter électriquement la première carte de circuit imprimé et la deuxième carte de circuit imprimé, et
où chaque substrat flexible de la pluralité de substrats flexibles inclut une première portion (510, 610) incluant un premier plot conducteur (511, 601) couplé à une première région conductrice (425) de la première carte de circuit imprimé, une deuxième portion (520, 620) incluant un deuxième plot conducteur (521, 602) couplé à une deuxième région conductrice (445) de la deuxième carte de circuit imprimé, et au moins un VIA (531, 532, 603) configuré pour connecter électriquement la première portion et la deuxième portion,
où la pluralité de substrats flexibles inclut un premier substrat flexible (500-1, 550) et un deuxième substrat flexible (500-3, 560), et
où le premier substrat flexible et le deuxième substrat flexible sont disposés de manière à être symétriques l'un par rapport à l'autre par rapport à un axe optique (L) de la lentille.

2. Dispositif électronique selon la revendication 1, où la première portion et la deuxième portion sont formées sensiblement selon la même forme.

3. Dispositif électronique selon la revendication 1, où le substrat flexible est au moins partiellement caché par la deuxième carte de circuit imprimé lorsque la deuxième carte de circuit imprimé est vue dans une direction de l'axe optique (L) de la lentille.

4. Dispositif électronique selon la revendication 1, où la première portion inclut une première région de plot (512) dans laquelle le premier plot conducteur est formé, une première région VIA (513, 514) dans laquelle le VIA (531, 532) est formé, et une première région d'extension (515-1, 515-2) configurée pour s'étendre de la première région de plot à la première région VIA,
où la deuxième portion inclut une deuxième région de plot (522) dans laquelle le deuxième plot conducteur est formé, une deuxième région VIA (523, 524) dans laquelle le VIA est formé, et une deuxième région d'extension (525-1, 525-2) configurée pour s'étendre de la deuxième région de plot à la deuxième région VIA,
où le substrat flexible inclut en outre une couche adhésive (538) disposée entre la première région VIA et la deuxième région VIA, et
où le VIA passe à travers la première région VIA, la deuxième région VIA, et la couche adhésive.

5. Dispositif électronique selon la revendication 4, où la première région d'extension inclut une région d'extension 1-1 configurée pour s'étendre de la première région de plot dans une première direction et une région d'extension 1-2 configurée pour s'étendre dans une deuxième direction opposée à la première direction, et
où la deuxième région d'extension inclut une région d'extension 2-1 configurée pour s'étendre de la deuxième région de plot dans la première direction et une région d'extension 2-2 configurée pour s'étendre dans la deuxième direction opposée à la première direction.

6. Dispositif électronique selon la revendication 5, où un espace dans lequel l'un ou plusieurs substrats flexibles sont disposés, est formé entre la première carte de circuit imprimé et la deuxième carte de circuit imprimé,
où une ligne centrale s'étendant à partir de l'axe optique de la lentille est définie dans l'espace,
où la région d'extension 1-1 et la région d'extension 2-1 s'étendent dans une direction vers la ligne centrale, et
où la région d'extension 1-2 et la région d'extension 2-2 s'étendent dans une direction qui s'éloigne de la ligne centrale.

7. Dispositif électronique selon la revendication 1, où le substrat flexible inclut plusieurs régions VIA (513, 523, 514, 524) dans lesquelles les VIA (531, 532) sont formés, une première région de plot (512) dans laquelle le premier plot conducteur est formé, et une deuxième région de plot (522) dans laquelle le deuxième plot conducteur est formé, et
où la pluralité de régions VIA inclut une première région VIA (513, 523) espacée d'un côté de la première région de plot et de la deuxième région de plot et une deuxième région VIA (514, 524) espacée d'un côté opposé de la première région de plot et de la deuxième région de plot.

8. Dispositif électronique selon la revendication 7, où une ligne centrale s'étendant à partir de l'axe optique de la lentille est définie dans la structure de connexion, et
où la première région VIA et la deuxième région VIA sont espacées de la ligne centrale par une distance sensiblement identique.

9. Dispositif électronique selon la revendication 1, où le VIA est formé à une position espacée de chacune de la première carte de circuit imprimé et de la deuxième carte de circuit imprimé par un espace prédéterminé.

10. Dispositif électronique selon la revendication 1, où le premier substrat flexible et le deuxième substrat flexible sont disposés de telle sorte qu'une ligne virtuelle s'étendant à partir de l'axe optique de la lentille passe entre le premier substrat flexible et le deuxième substrat flexible.
